# EUROPEAN PATENT SPECIFICATION

(11) **EP 2 129 739 B1**
(45) Date of publication and mention of the grant of the patent: **08.06.2011**
(21) Application number: 08739643.8
(22) Date of filing: 26.03.2008
(51) Int. Cl.: C09K 11/06, H05B 33/14, H01L 51/00

(54) **ORGANIC ELECTROLUMINESCENT DEVICE**
ORGANISCHE ELEKTROLUMINESZENZVORRICHTUNG
DISPOSITIF ELECTROLUMINESCENT ORGANIQUE

(30) Priority: 28.03.2007 JP 2007085961
(43) Date of publication of application: 09.12.2009
(73) Proprietor: FUJIFILM Corporation, Tokyo 106-0031 (JP)
(72) Inventor: TAKEDA, Akira, Ashigarakami-gun, Kanagawa (JP)
(74) Representative: HOFFMANN EITLE
(86) International application number: PCT/JP2008/056532
(87) International publication number: WO 2008/117889

(56) References cited:
- WO-A-2006/112582
- US-A1- 2002 045 061
- US-A1- 2006 046 098

## Description

### Technical Field

The present invention relates to an organic electroluminescent device (hereinafter also referred to as "organic EL device", "light-emitting device" or "device") capable of emitting light by converting electric energy into light. In particular, the present invention relates to an organic electroluminescent device excellent in luminescent characteristics and durability.

### Background Art

Various types of display devices using organic light-emitting materials (organic luminescent devices) are actively researched and developed these days. Above all, organic EL devices are attracting public attention as promising display devices for capable of emitting lights of high luminance with low voltage.

Also in recent years, the increase in efficiency of the devices has been advanced by the use of phosphorescent materials. As phosphorescent materials, indium complexes and platinum complexes are known. (Refer to US 6,303,238, WO 00/57676 and WO 00/70655.)

In the light-emitting layer of WO 00/70655, Ir(ppy) (iridium-tris(phenylpyridine)) as a dopant and CBP (4,4'-dicarbazolebiphenyl) as a host material are used in combination.

In WO 02/47440. an organic compound containing a deuterium atom is used, but WO 02/47440 dose not disclose any advantage or effect when the organic compound is used in combination with a phosphorescent metal complex material.

In JP-A-2005-48004, a carbazole material containing a deuterium atom and emitting phosphorescence at the ordinary temperature is used, but JP-A-2005-48004 does not disclose any advantage or effect when the carbazole material is used in combination with a phosphorescent metal complex material.

WO 2006/112582 relates to a deuterated organic electroluminescent material, a preparation method thereof and an organic light emitting diode using the same. The organic light emitting diode using the deuterated organic electroluminescent material is said to have remarkably improved emitting efficiency, brightness, power efficiency, thermal stability and the like.

US 2006/0046098 A1 and US 2002/004561 A1 relates to organic electroluminescence elements comprising: an anode layer, a cathode layer, and an organic luminescence layer therebetween, the organic luminescence layer having a carbazole derivative with a glass-transition temperature of 110 DEG C. or higher, and a phosphorescent dopant. The phosphorescent dopant is most preferably an iridium complex, such as tris(2-phenylpyridine)iridium.

### Disclosure of the Invention

An object of the invention is to provide a light-emitting device showing excellent efficiency (consumed electric power) and durability.

The above object can be achieved by the following means.
(1) An organic electroluminescent device comprising:
   a pair of electrodes; and
   at least one organic layer between the pair of electrodes, the at least one organic layer including a light-emitting layer,
   wherein the at least one organic layer contains a compound represented by formula (I), and the light-emitting layer contains a phosphorescent material of a platinum complex having a tetradentate ligand: 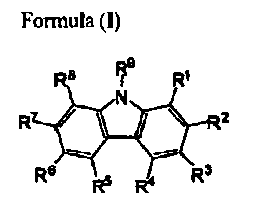
   wherein R¹ to R⁸ each independently represents a hydrogen atom or a substituent, and contiguous groups of R¹ to R⁸ may be bonded to each other to form a condensed ring; R⁹ represents an alkyl group, an alkenyl group, an aryl group, a hetero aryl group, or a silyl group, and each group may be substituted with a substituent; and at least one of R¹ to R⁹ represents a deuterium atom or a substituent containing a deuterium atom.
(2) The organic electroluminescent device as described in the above item (1), wherein the compound represented by formula (I) is contained in the light-emitting layer.
(3) The organic electroluminescent device as described in the above item (1) or (2), wherein the compound represented by formula (I) is contained in an organic layer contiguous to the light emitting layer.
(4) The organic electroluminescent device as described in any one of the above items (1) to (3), wherein the compound represented by formula (I) is contained in the light-emitting layer and an organic layer contiguous to the light-emitting layer.
(5) The organic electroluminescent device as described in any one of the above items (1) to (4), wherein the compound represented by formula (I) is a compound represented by formula (V): 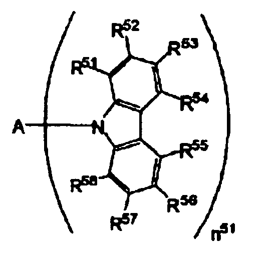 wherein R⁵¹ to R⁵⁸ each independently represents a hydrogen atom or a substituent, and contiguous substituents of R⁵¹ to R⁵⁸ may be bonded to each other to form a condensed ring; A represents a linking group; n⁵¹ represents an integer of from 2 to 6; and the compound represented by formula (V) contains at least one deuterium atom.
(6) The organic electroluminescent device as described in any one of items (1) to (5) above, wherein the phosphorescent material includes a compound represented by one of formulae (A), (B), (E) and (F): 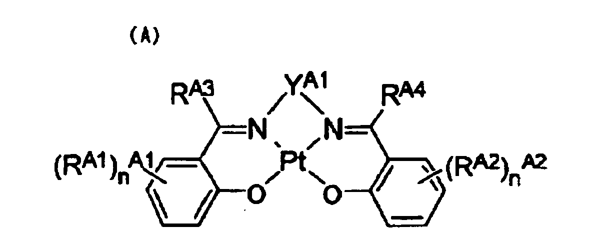 wherein R^{A3} and R^{A4} each independently represents a hydrogen atom or a substituent; R^{A1} and R^{A2} each independently represents a substituent, and when a plurality of R^{A1} and R^{A2} are present, the plurality of R^{A1} and R^{A2} may be the same or different, and R^{A1} and R^{A2} may be connected to each other to form a ring; n^{A1} and n^{A2} each independently represents an integer of from 0 to 4; and Y^{A1} represents a linking group; 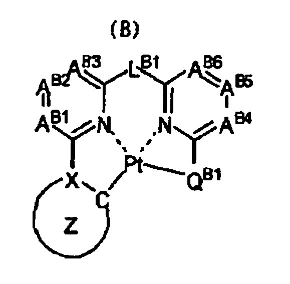 wherein A^{B1} to A^{B6} each independently represents C-R or N; R represents a hydrogen atom or a substituent; L^{B1} represents a single bond or a divalent linking group; X represents C or N; Z represents a 5- or 6-membered aromatic ring or heteroaromatic ring formed together
   with X-C; and Q^{B1} represents an anionic group bonding to Pt; 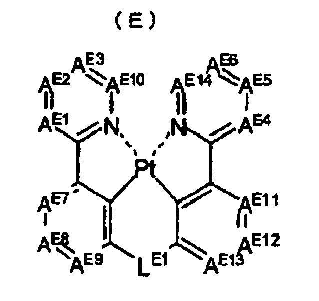 wherein A^{E1} to A^{E14} each independently represents C-R or N; R represents a hydrogen atom or a substituent; and L^{E1} represents a single bond or a divalent linking group; 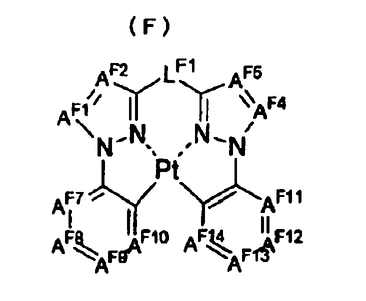 wherein A^{F1} to A^{F14} each independently represents C-R or N; R represents a hydrogen atom or a substituent; and L^{F1} represents a single bond or a divalent linking group.

### Advantageous Effects

According to an aspect of the invention, an organic electroluminescent device excellent in efficiency (consumed electric power) and durability can be provided.

### Best Mode for Carrying Out the Invention

An organic electroluminescent device according to an exemplary embodiment of the invention (hereinafter sometimes referred to as "a device of the invention") is an organic electroluminescent device including a pair of electrodes and at least one organic layer between the pair of electrodes, the at least one organic layer including a light-emitting layer. (The organic layer is a layer containing an organic compound, and the layer may be a layer containing an organic compound alone or may be a layer containing an inorganic compound in addition to the organic compound.) At least one of organic layers contains at least one compound represented by the following formula (I), and the light-emitting layer contains at least one phosphorescent material of a platinum complex (hereinafter sometimes referred to as "a platinum complex phosphorescent material") having a tetradentate ligand (quadridentate ligand). By using the compound represented by formula (I) and the platinum complex phosphorescent material having a tetradentate ligand in combination, very excellent driving efficiency and driving durability can be obtained.

A compound represented by formula (I) of the invention is excellent in chemical stability, hardly accompanied by decomposition of the material during driving of the device, and capable of preventing reduction of efficiency of the organic electroluminescent device using the platinum complex phosphorescent material having a tetradentate ligand, and reduction of the life time of the device due to the decomposed product.

The compound represented by formula (I) is described below.

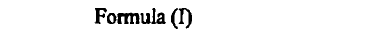

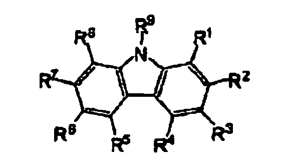

In formula (I), R¹ to R⁸ each independently represents a hydrogen atom or a substituent, and contiguous substituents of R¹ to R⁸ may be bonded to each other to form a condensed ring; R⁹ represents an alkyl group, an alkenyl group, an aryl group, a hetero aryl group, or a silyl group, and each group may be substituted with a substituent; and at least one of R¹ to R⁹ represents a deuterium atom or a substituent containing a deuterium atom.

Substituents represented by R¹ to R⁸ are not especially restricted. For example, an alkyl group, an alkenyl group, an alkynyl group, an aryl group, a hetero aryl group, an amino group, an alkoxyl group, an aryloxy group, a heterocyclic oxy group, an acyl group, an alkoxycarbonyl group, an aryloxycarbonyl group, an acyloxy group, an acylamino group, an alkoxycarbonylamino group, an aryloxycarbonylamino group, a sulfonylamino group, a sulfamoyl group, a carbamoyl group, an alkylthio group, an arylthio group, a heterocyclic thio group, a sulfonyl group, a sulfinyl group, a ureido group, a phosphoric acid amido group, a hydroxyl group, a mercapto group, a halogen atom, a cyano group, a sulfo group, a carboxyl group, a nitro group, a hydroxamic acid group, a sulfino group, a hydrazino group, an imino group, a heterocyclic group, a silyl group, a silyloxy group, a deuterium atom, etc., are exemplified. These substituents may further be substituted with other substituent, and these substituents may be bonded to each other to form a ring.

The alkyl group has preferably from 1 to 30 carbon atoms, more preferably from 1 to 20 carbon atoms, and especially preferably from I to 10 carbon atoms, and, e.g., methyl, methyl, n-propyl iso-propyl, n-butyl, tert-butyl, n-octyl, n-nonyl, n-decyl, n-dodecyl, n-octadecyl, n-hexadecyl, cyclopropyl, cyclobutyl, cyclopentyl, cyclohexyl, cyclooctyl, 1-adamantyl, trifluoromethyl, etc., are exemplified.

The alkenyl group has preferably from 2 to 30 carbon atoms, more preferably from 2 to 20 carbon atoms, and especially preferably from 2 to 10 carbon atoms, and, e.g., vinyl, allyl, 1-propenyl, 1-isopropenyl, 1-butenyl, 2-butenyl, 3-pentenyl, etc., are exemplified.

The alkynyl has preferably from 2 to 30 carbon atoms, more preferably from 2 to 20 carbon atoms, and especially preferably from 2 to 10 carbon atoms, and, e.g., ethynyl, propargyl, 1-propynyl, 3-pentynyl, etc., are exemplified.

The aryl group has preferably from 6 to 30 carbon atoms, more preferably from 6 to 20 carbon atoms, and especially preferably from 6 to 12 carbon atoms, and, e.g., phenyl, o-methylphenyl, m-methylphenyl, p-methylphenyl, 2,6-xylyl, p-cumenyl, mesityl, naphthyl, anthranyl, etc., are exemplified.

The hetero aryl group has preferably from 1 to 30 carbon atoms, more preferably from 1 to 12 carbon atoms, and the hetero atom is, for example, a nitrogen atom, an oxygen atom, or a sulfur atom. Specifically, e.g., imidazolyl, pyrazolyl, pyridyl, pyrazyl, pyrimidyl, triazinyl, quinolyl, isoquinolyl, pyrrolyl, indolyl, furyl, thienyl, benzoxazolyl, benzimidazolyl, benzothiazolyl, carbazolyl, azepinyl, etc., are exemplified.

The amino group has preferably from 0 to 30 carbon atoms, more preferably from 0 to 20 carbon atoms, and especially preferably from 0 to 10 carbon atoms, and, e.g., amino, methylamino, dimethylamino, diethylamino, benzylamino, diphenylamino, ditolylamino, etc., are exemplified.

The alkoxyl group has preferably from 1 to 30 carbon atoms, more preferably from 1 to 20 carbon atoms, and especially preferably from 1 to 10 carbon atoms, and, e.g., methoxy, ethoxy, butoxy, 2-ethylhexyloxy, etc., are exemplified.

The aryloxy group has preferably from 6 to 30 carbon atoms, more preferably from 6 to 20 carbon atoms, and especially preferably from 6 to 12 carbon atoms, and, e.g., phenyloxy, 1-naphthyloxy, 2-naphthyloxy, etc., are exemplified.

The heterocyclic oxy group has preferably from 1 to 30 carbon atoms, more preferably from I to 20 carbon atoms, and especially preferably from I to 12 carbon atoms, and, e.g., pyridyloxy, pyrazyloxy, pyrimidyloxy, quinolyloxy, etc., are exemplified.

The acyl group has preferably from 1 to 30 carbon atoms, more preferably from 1 to 20 carbon atoms, and especially preferably from I to 12 carbon atoms, and, e.g., acetyl, benzoyl, formyl, pivaloyl, etc., are exemplified.

The alkoxycarbonyl group has preferably from 2 to 30 carbon atoms, more preferably from 2 to 20 carbon atoms, and especially preferably from 2 to 12 carbon atoms, and, e.g., methoxycarbonyl, ethoxycarbonyl, etc., are exemplified.

The aryloxycarbonyl group has preferably from 7 to 30 carbon atoms, more preferably from 7 to 20 carbon atoms, and especially preferably from 7 to 12 carbon atoms, and, e.g., phenyloxycarbonyl, etc., are exemplified.

The acyloxy group has preferably from 2 to 30 carbon atoms, more preferably from 2 to 20 carbon atoms, and especially preferably from 2 to 10 carbon atoms, and, e.g., acetoxy, benzoyloxy, etc., are exemplified.

The acylamino group has preferably from 2 to 30 carbon atoms, more preferably from 2 to 20 carbon atoms, and especially preferably from 2 to 10 carbon atoms, and, e.g., acetylamino, benzoylamino, etc., are exemplified.

The alkoxycarbonylamino group has preferably from 2 to 30 carbon atoms, more preferably from 2 to 20 carbon atoms, and especially preferably from 2 to 12 carbon atoms, and, e.g., methoxycarbonylamino, etc., are exemplified.

The aryloxycarbonylamino group has preferably from 7 to 30 carbon atoms, more preferably from 7 to 20 carbon atoms, and especially preferably from 7 to 12 carbon atoms, and, e.g., phenyloxycarbonylamino, etc., are exemplified.

The sulfonylamino group has preferably from 1 to 30 carbon atoms, more preferably from 1 to 20 carbon atoms, and especially preferably from 1 to 12 carbon atoms, and, e.g., methanesulfonylamino, benzenesulfonylamino, etc., are exemplified.

The sulfamoyl group has preferably from 0 to 30 carbon atoms, more preferably from 0 to 20 carbon atoms, and especially preferably from 0 to 12 carbon atoms, and, e.g., sulfamoyl, methylsulfamoyl, dimethylsulfamoyl, phenylsulfamoyl, etc., are exemplified.

The carbamoyl group has preferably from 1 to 30 carbon atoms, more preferably from 1 to 20 carbon atoms, and especially preferably from 1 to 12 carbon atoms, and, e.g., carbamoyl, methylcarbamoyl, diethylcarbamoyl, phenylcarbamoyl, etc., are exemplified.

The alkylthio group has preferably from 1 to 30 carbon atoms, more preferably from 1 to 20 carbon atoms, and especially preferably from 1 to 12 carbon atoms, and, e.g., methylthio, ethylthio, etc., are exemplified.

The arylthio group has preferably from 6 to 30 carbon atoms, more preferably from 6 to 20 carbon atoms, and especially preferably from 6 to 12 carbon atoms, and, e.g., phenylthio, etc., are exemplified.

The heterocyclic thio group has preferably from 1 to 30 carbon atoms, more preferably from 1 to 20 carbon atoms, and especially preferably from 1 to 12 carbon atoms, and, e.g., pyridylthio, 2-benzimidazolylthio, 2-benzoxazolylthio, 2-benzothiazolylthio, etc., are exemplified.

The sulfonyl group has preferably from 1 to 30 carbon atoms, more preferably from 1 to 20 carbon atoms, and especially preferably from 1 to 12 carbon atoms, and, e.g., mesyl, tosyl, trifluoromethanesulfonyl, etc., are exemplified.

The sulfinyl group has preferably from 1 to 30 carbon atoms, more preferably from 1 to 20 carbon atoms, and especially preferably from 1 to 12 carbon atoms, and, e.g., methanesulfinyl, benzenesulfinyl, etc., are exemplified.

The ureido group has preferably from 1 to 30 carbon atoms, more preferably from 1 to 20 carbon atoms, and especially preferably from 1 to 12 carbon atoms, and, e.g., ureido, methylureido, phenylureido, etc., are exemplified.

The phosphoric acid amido group has preferably from 1 to 30 carbon atoms, more preferably from 1 to 20 carbon atoms, and especially preferably from 1 to 12 carbon atoms, and, e.g., diethylphosphoric acid amido, phenylphosphoric acid amido, etc., are exemplified.

As the halogen atom, e.g., a fluorine atom, a chlorine atom, a bromine atom, an iodine atom, etc., are exemplified.

The heterocyclic group has preferably from 1 to 30 carbon atoms, more preferably from 1 to 12 carbon atoms, and as the hetero atom is, e.g., a nitrogen atom, an oxygen atom, or a sulfur atom, specifically, e.g., piperidyl, morpholino, pyrrolidyl, etc., are exemplified.

The silyl group has preferably from 3 to 40 carbon atoms, more preferably from 3 to 30 carbon atoms, and especially preferably from 3 to 24 carbon atoms, and, e.g., trimethylsilyl, triethylsilyl, triisopropylsilyl, methyldiphenylsilyl, dimethyl-tert-butylsilyl, dimethylphenylsilyl, diphenyl-tert-butylsilyl, triphenylsilyl, tri-1-naphthylsilyl, tri-2-naphthylsilyl, etc., are exemplified.

The silyloxy group has preferably from 3 to 40 carbon atoms, more preferably from 3 to 30 carbon atoms, and especially preferably from 3 to 24 carbon atoms, and, e.g., trimethyl-silyloxy, triphenylsilyloxy, etc., are exemplified.

As the substituents represented by R¹ to R⁸, a deuterium atom, an alkyl group, an aryl group, a hetero aryl group, a halogen group, a cyano group, and a silyl group are preferred; a deuterium atom, an alkyl group, a hetero aryl group, a halogen group, a cyano group, and a silyl group are more preferred; and a deuterium atom, an alkyl group, a hetero aryl group, and a silyl group are especially preferred. These substituents may further be substituted with other substituent, and these substituents may be bonded to each other to form a ring.

As the alkyl groups represented by R¹ to R⁸, the preferred are methyl, ethyl, n-propyl, isopropyl, n-butyl, tert-butyl, n-octyl, cyclopropyl, cyclopentyl, cyclohexyl, 1-adamantyl, and trifluoromethyl; the more preferred are methyl, isopropyl, tert-butyl, n-octyl, cyclopentyl, cyclohexyl, 1-adamantyl, and trifluoromethyl; and the especially preferred are tert-butyl, cyclohexyl, 1-adamantyl, and trifluoromethyl. These substituents may further be substituted with other substituent, and these substituents may be bonded to each other to form a ring.

As the hetero aryl groups represented by R¹ to R⁸, the preferred are imidazolyl, pyrazolyl, pyridyl, quinolyl, isoquinolyl, pyrrolyl, indolyl, furyl, thienyl, benzoxazolyl, benzimidazolyl, benzothiazolyl, carbazolyl, and azepinyl; the more preferred are imidazolyl, pyrazolyl, quinolyl, indolyl, furyl, thienyl, benzimidazolyl, carbazolyl, and azepinyl; and the especially preferred are indolyl, furyl, thienyl, benzimidazolyl, carbazolyl, and azepinyl. These substituents may further be substituted with other substituent, may form a condensed ring structure, and these substituents may be bonded to each other to form a ring.

As the silyl groups represented by R¹ to R⁸, the preferred are trimethylsilyl, triethylsilyl, triisopropylsilyl, methyldiphenylsilyl, dimethyl-tert-butylsilyl, dimethylphenylsilyl, diphenyl-tert-butylsilyl, and triphenylsilyl; the more preferred are trimethylsilyl, triisopropylsilyl, dimethyl-tert-butylsilyl, diphenyl-tert-butylsilyl, and triphenylsilyl; and the especially preferred are trimethyl- silyl, dimethyl-tert-butylsilyl, and triphenylsilyl. These substituents may further be substituted with other substituent, and these substituents may be bonded to each other to form a ring.

As the substituents represented by R² and R⁷, the preferred are an alkyl group, an aryl group, a silyl group and a deuterium atom; the more preferred are an alkyl group, a silyl group and a deuterium atom; and the especially preferred are a tert-butyl group, an adamantyl group, a trimethylsilyl group, a triphenylsilyl group, and a deuterium atom.

As the substituents represented by R³ and R⁶, the preferred are an alkyl group, an aryl group, a silyl group and a deuterium atom; the more preferred are an alkyl group, a silyl group and a deuterium atom; and the especially preferred are a tert-butyl group, an adamantyl group, a trimethylsilyl group, a triphenylsilyl group, and a deuterium atom.

The specific examples of the combinations of substituents represented by R¹ to R⁸ are shown below, but the invention is not restricted to these compounds. In the structural formulae, D represents a deuterium atom.

For example, in formula (a-0), all of R¹ to R⁸ represent a hydrogen atom, in formula (a-2), all of R¹, R², R⁴, R⁵, R⁷ and R⁸ represent a hydrogen atom, and R³ and R⁶ represent a deuterium atom, and in formula (a-4), all of R¹ to R⁸ represent a deuterium atom.

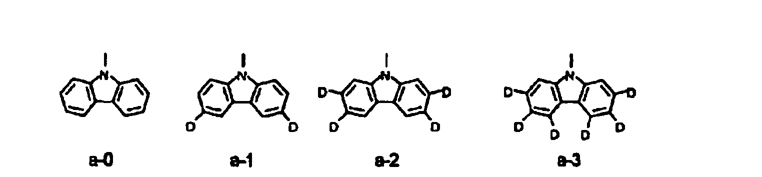

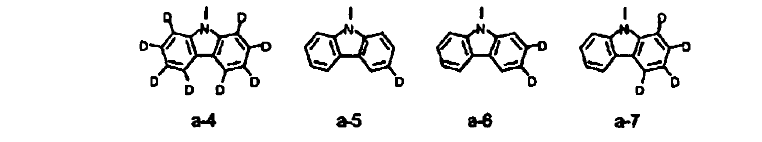

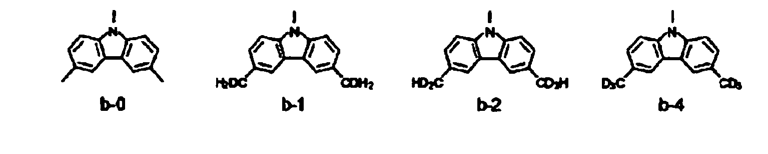

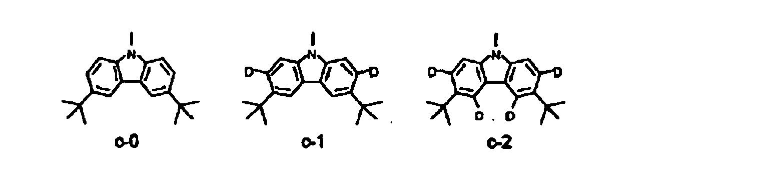

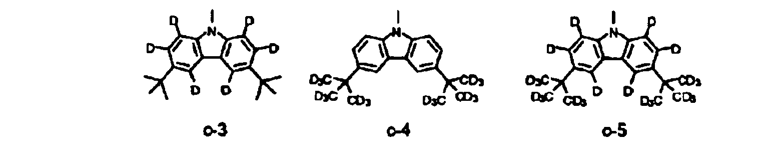

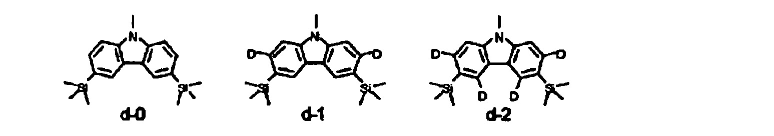

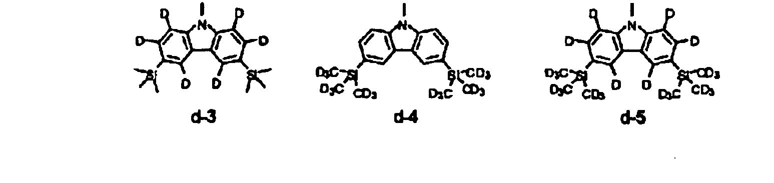

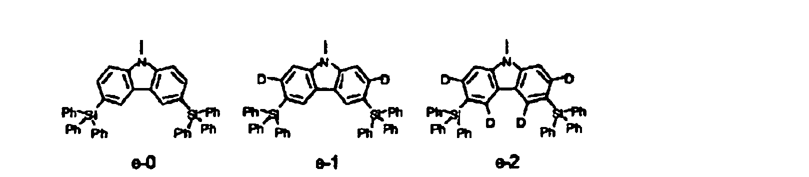

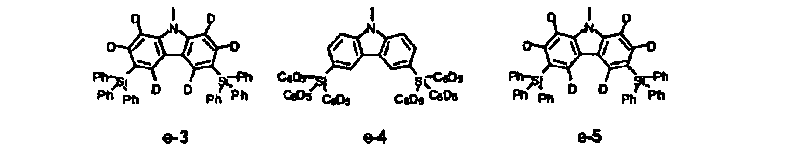

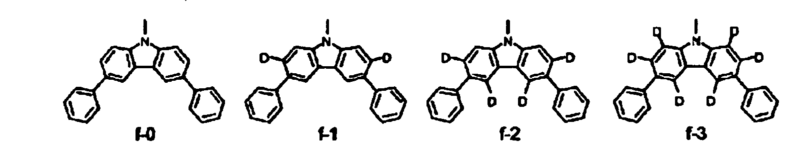

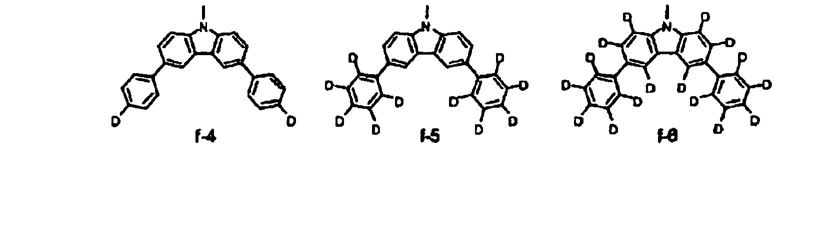

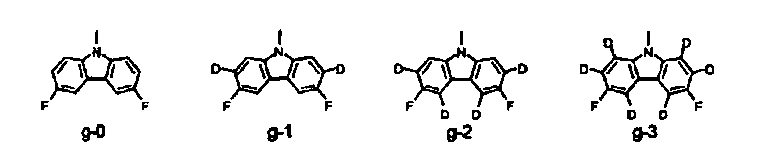

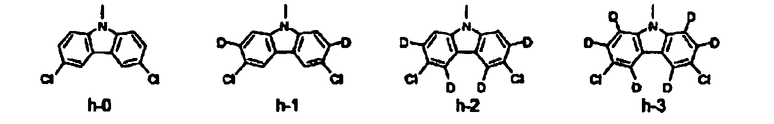

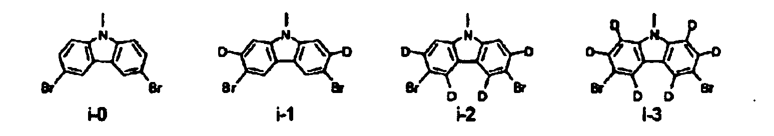

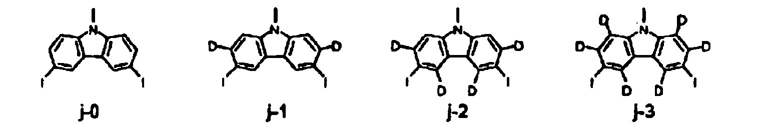

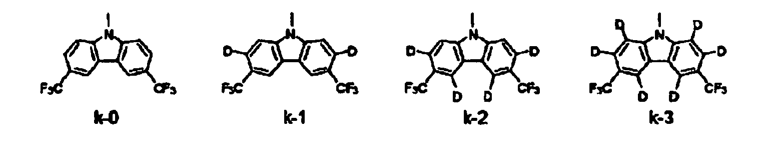

R⁹ represents an alkyl group, an alkenyl group, an aryl group, a hetero aryl group, or a silyl group, preferably an aryl group, a hetero aryl group, or a silyl group, more preferably an aryl group or a hetero aryl group, and especially preferably represents an aryl group. These substituents may further be substituted with other substituent, and the examples of the other substituent include those as above-exemplified as the examples of the substituents represented by R¹ to R⁸.

As the aryl group represented by R⁹, the preferred are phenyl, o-methylphenyl, 2,6-xylyl, and mesityl, the more preferred are phenyl and mesityl, and the especially preferred is a phenyl group. These substituents may form a condensed ring structure, these substituents may be bonded to each other to form a ring, e.g., biphenyl, naphthyl, anthranyl, phenanthryl, pyrenyl, naphthacenyl, etc., are exemplified. These substituents may further be substituted with other substituent.

A plurality of structures including carbazole and R¹ to R⁸ may be bonded to R⁹, preferably from 1 to 6, more preferably from 1 to 3, and especially preferably from 1 to 2.

For example, the specific examples of the substituent represented by R⁹ wherein one structure including carbazole and R¹ to R⁸ is bonded are shown below, however, the invention is not restricted to these compounds. In the following formula, * is the part to which the nitrogen atom of the carbazole is to be bonded.

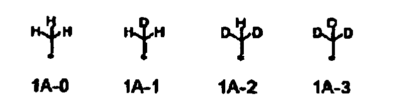

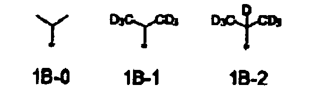

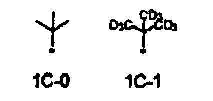

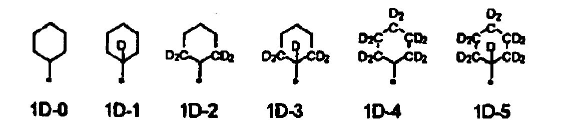

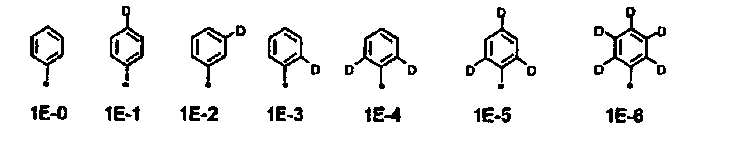

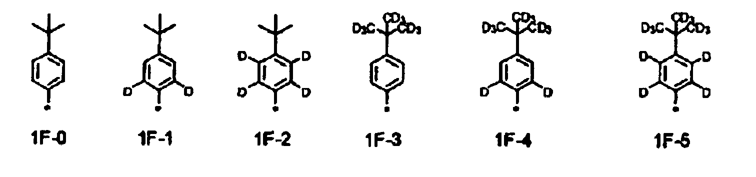

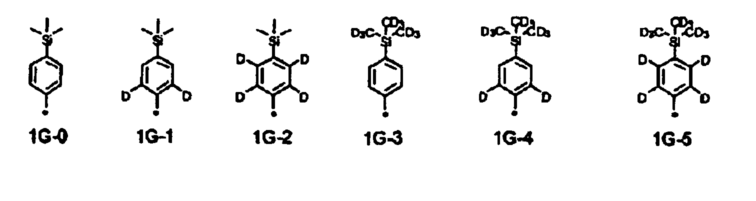

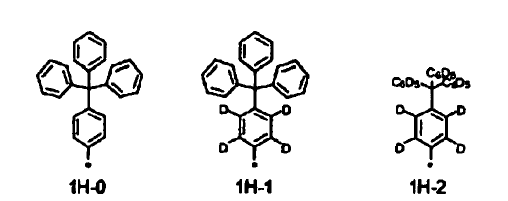

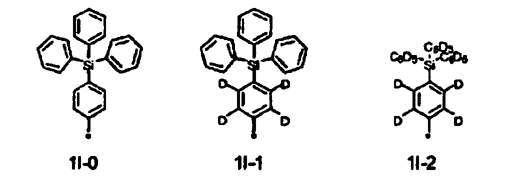

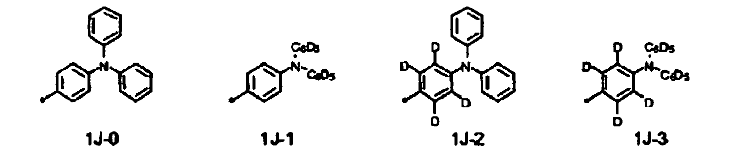

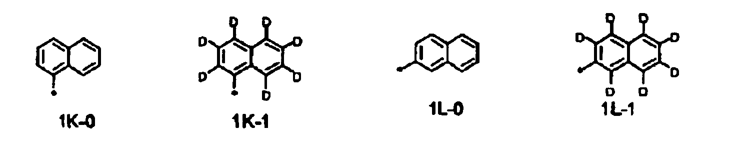

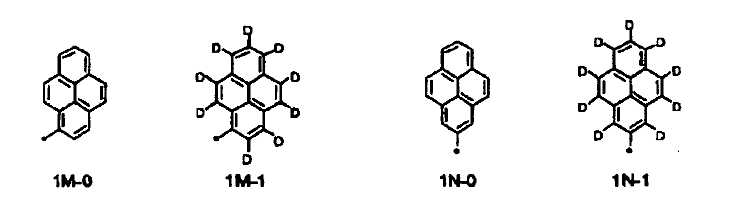

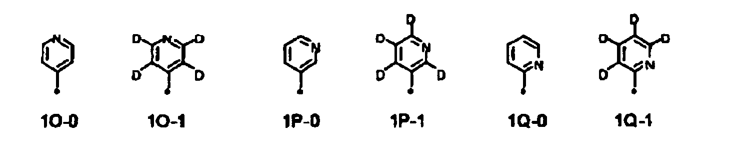

For example, the specific examples of the substituent represented by R⁹ wherein two structures including carbazole and R¹ to R⁸ are bonded are shown below, however, the invention is not restricted to these compounds. In the following formulae, * is the part to which the nitrogen atom of the carbazole is to be bonded.

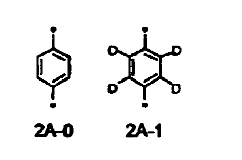

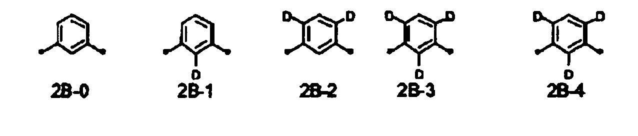

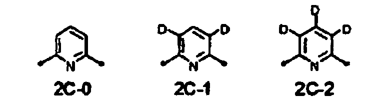

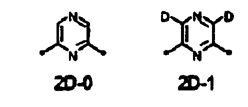

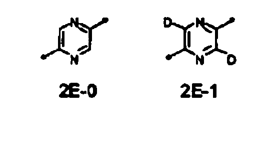

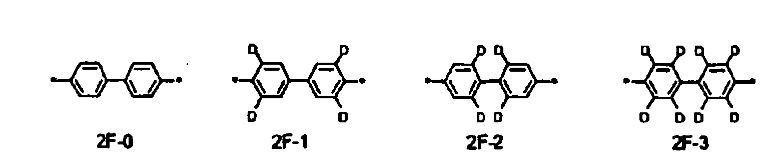

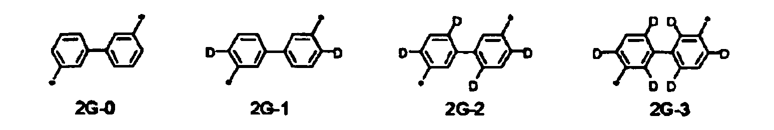

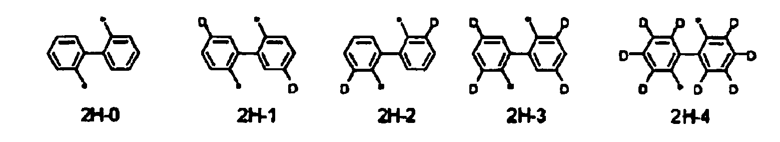

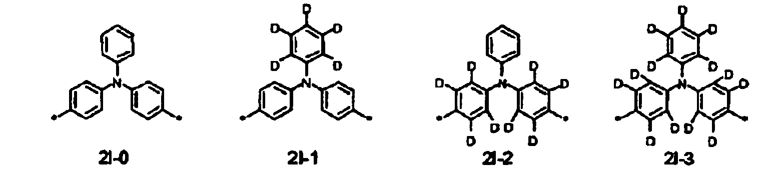

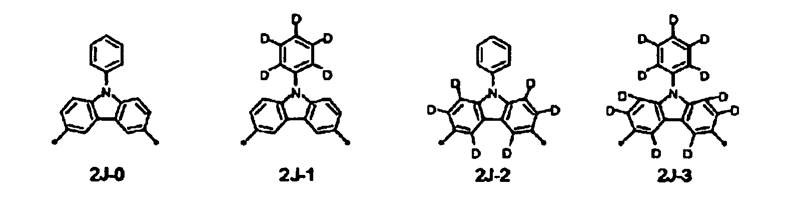

For example, the specific examples of the substituent represented by R⁹ wherein three structures including carbazole and R¹ to R⁸ are bonded are shown below, however, the invention is not restricted to these compounds. In the following formulae, * is the part to which the nitrogen atom of the carbazole is to be bonded.

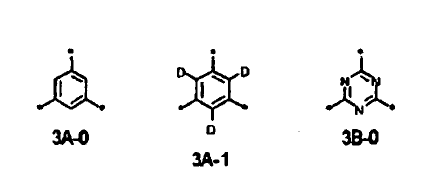

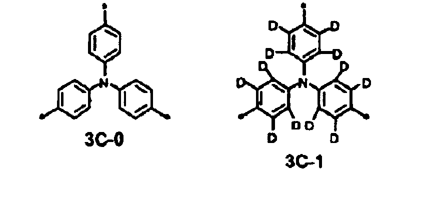

For example, the specific examples of the substituents represented by R⁹ wherein four structures including carbazole and R¹ to R⁸ are bonded are shown below, however, the invention is not restricted to these compounds. In the following formulae, * is the part to which the nitrogen atom of the carbazole is to be bonded.

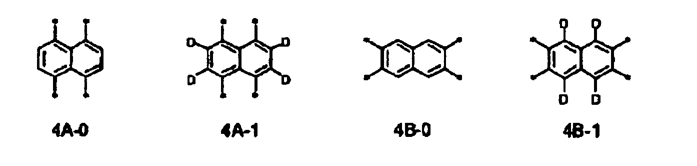

For example, the specific example of the substituent represented by R⁹ wherein six structures including carbazole and R¹ to R⁸ are bonded are shown below, however, the invention is not restricted to the compound. In the following formula, * is the part to which the nitrogen atom of the carbazole is to be bonded.

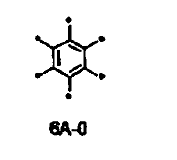

In formula (I), at least one of R¹ to R⁹ represents a deuterium atom or a substituent containing a deuterium atom.

In the invention, the fact that at least one of R¹ to R⁹ represents a deuterium atom or a substituent containing a deuterium atom means that the ratio of the deuterium atom to the hydrogen atom (the number of deuterium atoms / the number of hydrogen atoms) at a site where the deuterium atom can be bonded is included in the range of from 100/0 to 1/99.

The range of the ratio of deuterium atom and hydrogen atom is preferably from 100/0 to 5/95, more preferably from 100/0 to 50/50, and especially preferably from 100/0 to 80/20.

Preferably all of R¹ to R⁸ represent a deuterium atom, more preferably all or any of R¹, R³, R⁶ and R⁸ represents a deuterium atom, and especially preferably both or any one of R³ and R⁶ represents a deuterium atom.

The compound represented by formula (I) is especially preferably represented by formula (V). The compound represented by formula (V) is described below.

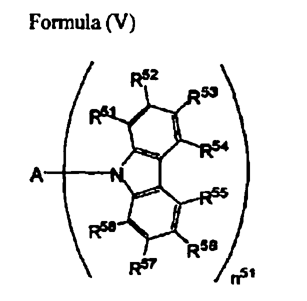

In formula (V), R⁵¹ to R⁵⁸ each represents a hydrogen atom or a substituent, and contiguous substituents of R⁵¹ to R⁵⁸ may be bonded to each other to form a condensed ring; A represents a linking group; n⁵¹ represents an integer of from 2 to 6; and the compound represented by formula (V) contains at least one deuterium atom.

R⁵¹ to R⁵⁸ have the same meaning as R¹ to R⁸ in the compound represented by formula (I), respectively, and the preferred ranges are also the same.

n⁵¹ is preferably from 2 to 4, more preferably 2 or 3, and especially preferably 2.

The linking group represented by A is preferably alkylene, arylene, hetero arylene, or silylene, more preferably arylene or hetero arylene, and especially preferably arylene. These linking groups may further be substituted with, e.g., the substituent represented by R¹.

Arylene is preferably phenylene, naphthylene, biphenylene, or terphenylene, more preferably phenylene or biphenylene, and especially preferably phenylene.

Phenylene is preferably 1,2,3,4,5,6-hexa-substituted phenylene, 1,2,4,5-tetra-substituted phenylene, 1,3,5-tri-substituted phenylene, 1,2-di-substituted phenylene, 1,3-di-substituted phenylene, or 1,4-di-substituted phenylene, more preferably 1,2-di-substituted phenylene, 1,3-di-substituted phenylene, or 1,4-di-stubstituted phenylene, and especially preferably 1,3-di-substituted phenylene or 1,4-di- substituted phenylene.

Hetero arylene is preferably di-substituted pyridylene or di-substituted N-phenylcarbazolylene, more preferably 2,6-di-substituted pyridylene, 3,5-di-substituted pyridylene, or 3,6-di-substituted N-phenylcarbazolylene, and especially preferably 3,6-di-substituted N-phenylcarbazolylene.

In the compound represented by formula (V), to contain a deuterium atom means that the ratio of the deuterium atom to the hydrogen atom (atom number of deuterium atoms/atom number of hydrogen atoms) at a site where the deuterium atom can be bonded is included in the range of from 100/0 to 1/99.

The range of the ratio of the deuterium atom to the hydrogen atom is preferably from 100/0 to 5/95, more preferably from 100/0 to 50/50, and especially preferably from 100/0 to 80/20.

The compound represented by formula (I) of the invention may be a low molecular weight compound, or may be an oligomer compound, or may be a polymer compound having the structure represented by formula (I) in the main chain or side chain (weight average molecular weight (polystyrene conversion) is preferably from 1,000 to 5,000,000, more preferably from 2,000 to 1,000,000, and still more preferably from 3,000 to 100,000). The compound represented by formula (I) is preferably a low molecular weight compound.

When the compound represented by formula (I) of the invention is an oligomer compound, or a polymer compound having the structure represented by formula (I) in the main chain or side chain, and when the compound is contained in the main chain, it is preferred that two or more of R¹ to R⁹ are contained in the main chain, more preferably two or more of R³, R⁶ and R⁹ are contained in the main chain, and especially preferably R³ and R⁶ are contained in the main chain. When the compound is contained as the side chain, it is preferred that any of R¹ to R⁹ is contained in the side chain, more preferably any of R³, R⁶ and R⁹ is contained in the side chain, and especially preferably R⁹ is contained in the side chain.

In the invention, the use of the compound represented by formula (I) of the invention is not restricted, and may be contained in any layer of the organic layers. The compound represented by formula (I) of the invention is preferably contained in any of the light-emitting layer, hole injecting layer, hole transporting layer, electron transporting layer, electron injecting layer, exciton blocking layer, and charge blocking layer, or two or more of these layers.

It is preferred in the invention for the compound represented by formula (I) to be contained in any of the light-emitting layer and the layer contiguous to the light-emitting layer, and the compound represented by formula (I) may be contained in both layers of the light-emitting layer and the layer contiguous to the light-emitting layer.

It is preferred that the compound represented by formula (I) of the invention is contained in the light-emitting layer by I to 100 mass% (weight%), more preferably contained by 50 to 100 mass%, and still more preferably contained by 80 to 100 mass%.

When the compound represented by formula (I) of the invention is contained in a layer other than the light-emitting layer, it is preferred to be contained by 1 to 100 mass%, more preferably contained by 50 to 100 mass%, and still more preferably contained by 80 to 100 mass%.

The specific examples of the compounds represented by formula (I) are shown below, but the invention is not restricted to these compounds.

For example, exemplified compound (1-1) shows the combination of (a-1) and (2F-0), and exemplified compound (1-6) means the combination of (a-4) and (2F-3).

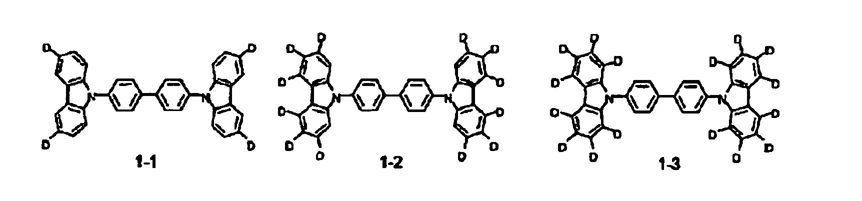

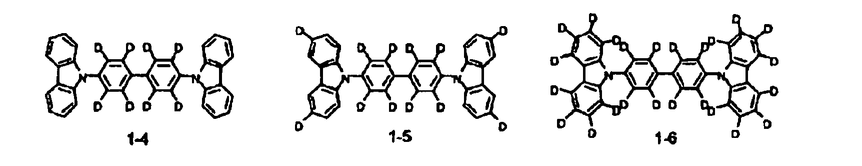

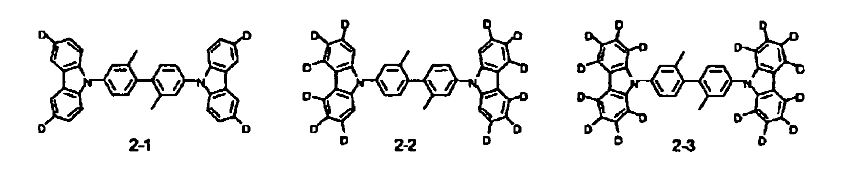

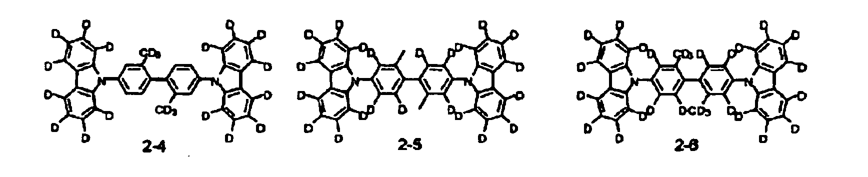

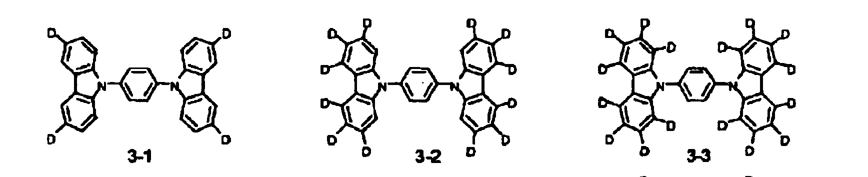

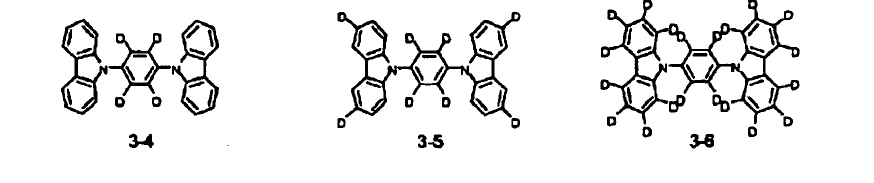

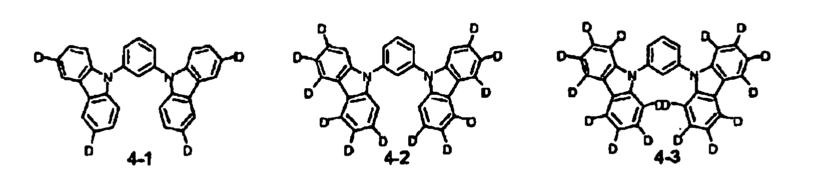

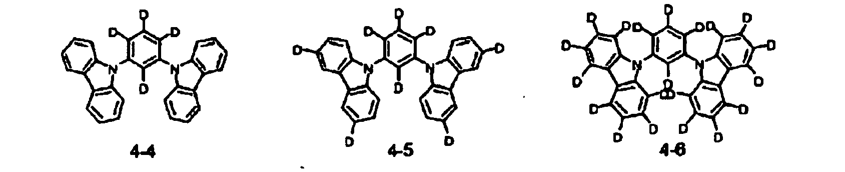

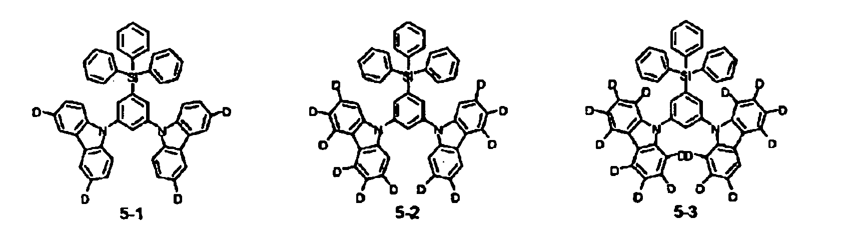

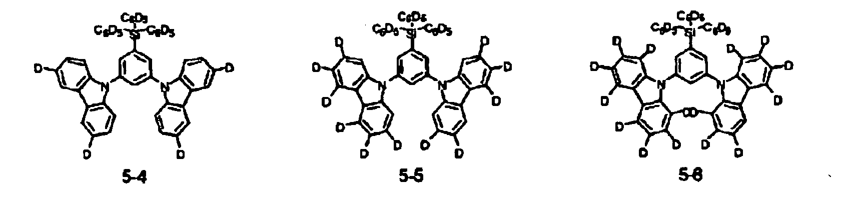

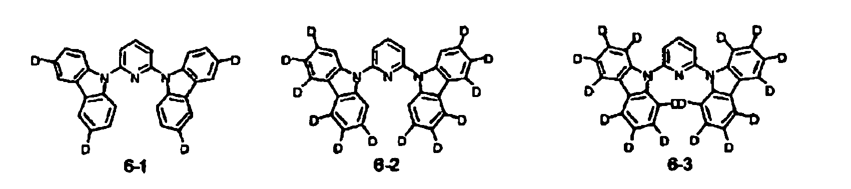

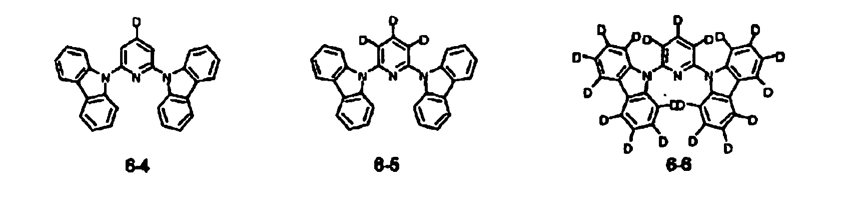

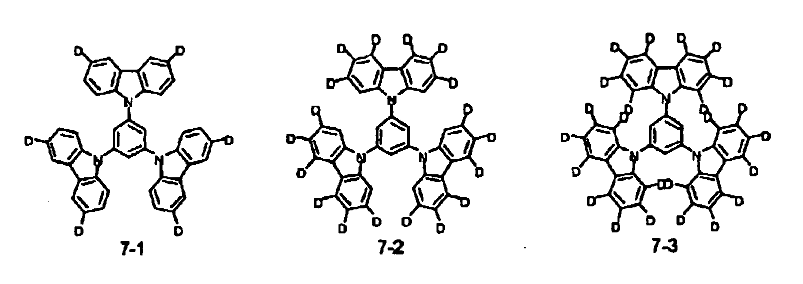

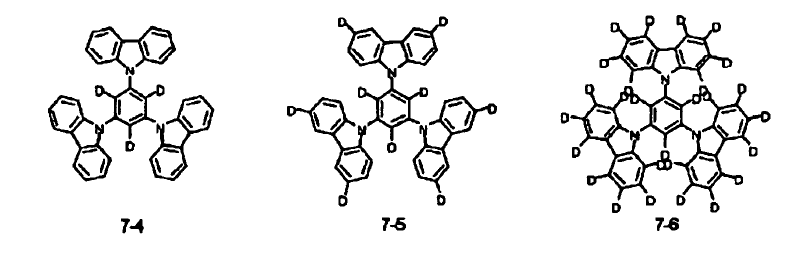

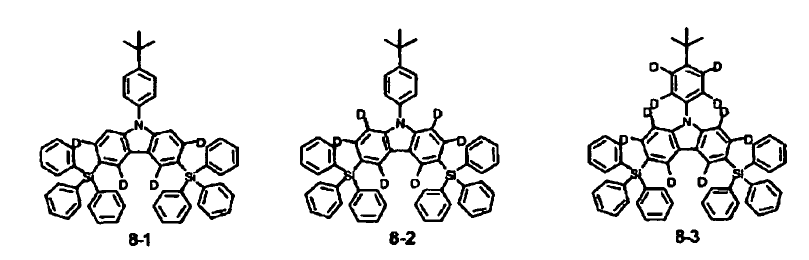

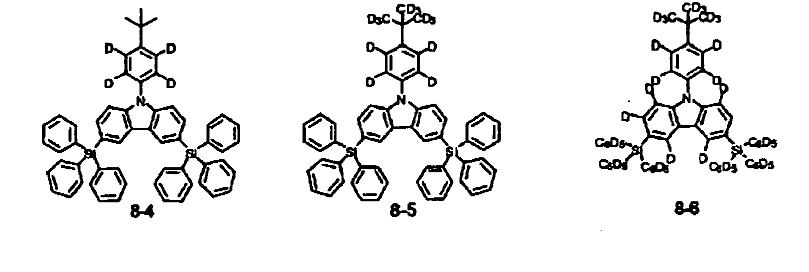

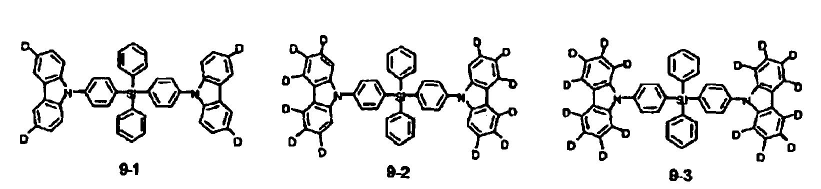

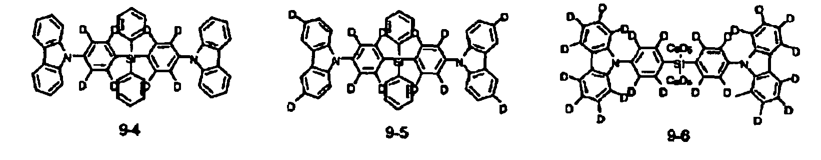

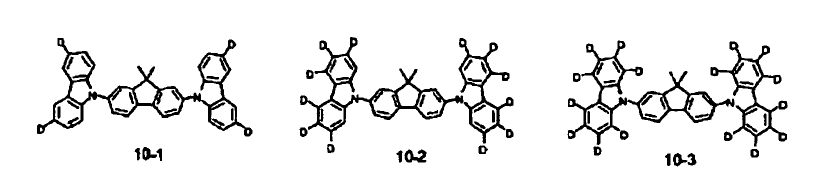

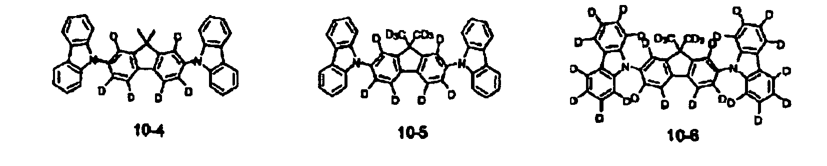

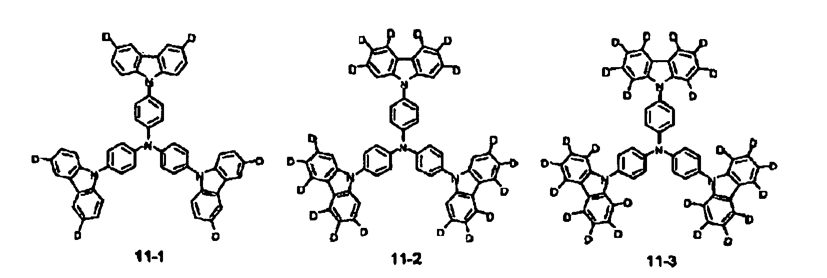

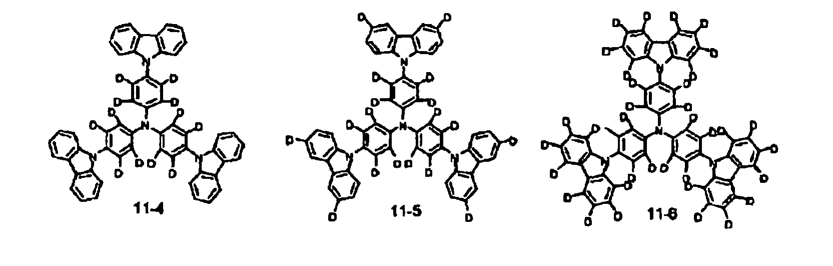

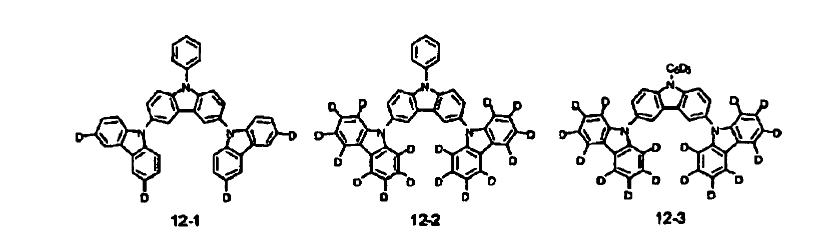

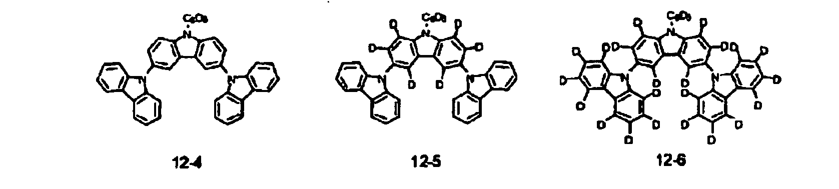

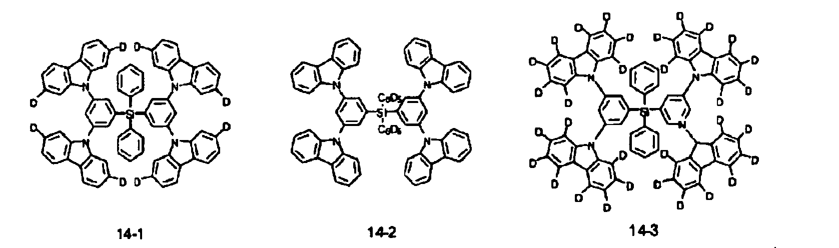

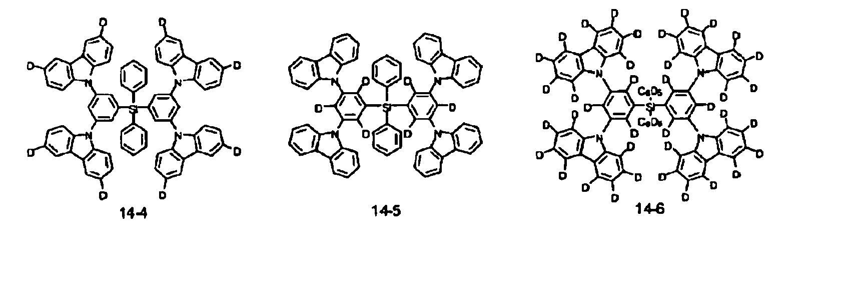

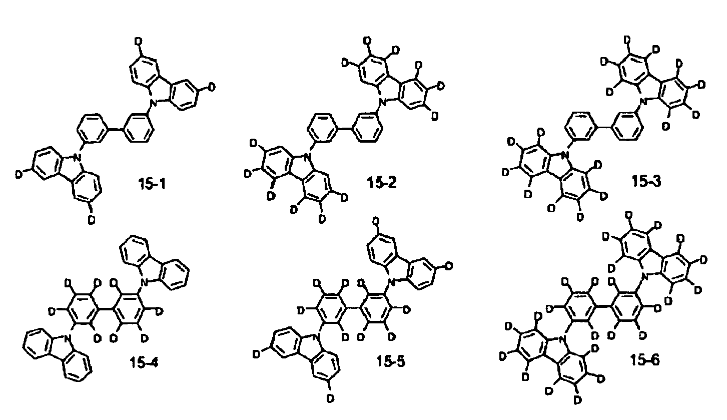

The specific examples of polymer compound and oligomer compound containing the compound represented by formula (I) are shown below, but the invention is not restricted to these compounds. In the case where the compound represented by formula (I) is a polymer compound, the polymer compound may be a homopolymer compound or a copolymer, and the copolymer may be any of a random copolymer, an alternating copolymer, and a block copolymer. In the formulae below, m/n means the molar ratio of each monomer contained in the polymer, and m is an integer of from 1 to 100, n is from 0 to 99, and the sum of m and n is 100.

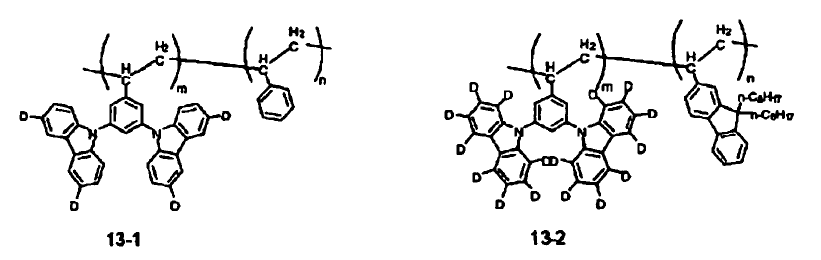

The specific examples of the platinum complex phosphorescent material having a tetradentate ligand include compounds disclosed in WO 2004/108857.

As the platinum complex phosphorescent material having a tetradentate ligand, more specifically, preferred are compounds described in US 6,653,654, WO 2004/099339, WO 2004/108857,JP-A-2005-310733,JP-A-2005-317516,JP-A-2006-261623,JP-A-2006-93542, JP-A-2006-256999, WO 2006/098505, JP-A-2007-19462, JP-A-2007-96255, JP-A-2007-96259, WO 2005/042444, JP-A-2006-232784, US 2006/0134461, and WO 2005/042550.

As the platinum complex phosphorescent material having a tetradentate ligand, those containing a 2-arylpyridine derivative, a 2-(1-pyrazolyl)pyridine derivative or a 1-arylpyrazole derivative as a partial structure of the ligand are preferred; those containing a 2-arylpyridine derivative or a 2-(1-pyrazolyl)pyridine derivative as a partial structure of the ligand are more preferred, and those containing a 1-arylpyrazole derivative as a partial structure of the ligand are particularly preferred.

The above-described partial structures of the ligand (e.g., a 2-arylpyridine derivative, a 2-(1-pyrazolyl)pyridine derivative, and a 1-arylpyrazole derivative) are connected to each other at an appropriate site thereof to constitute a tetradentate ligand.

In the case where the ligand contains 2-arylpyridine derivatives as a partial structure thereof, the 2-arylpyridine derivatives are connected to each other preferably in such manner that one 2-arylpyridine derivative is connected, at 6-position of the pyridine ring and/or meta-position of the aryl group with respect to the pyridine ring thereof, to the other 2-arylpyridine derivative at 6-position of the pyridine ring and/or meta-position of the aryl group with respect to the pyridine ring thereof; more preferably in such manner that the two 2-arylpyridine derivatives are connected to each other each at 6-position of the pyridine ring thereof or each at meta-position of the aryl group with respect to the pyridine ring thereof; and particularly preferably in such manner that the two 2-arylpyridine derivatives are connected to each other each at 6-position of the pyridine ring thereof.

In the case where the ligand contains 2-(1-pyrazolyl)pyridine derivatives as a partial structure thereof, the 2-(1-pyrazolyl)pyridine derivatives are connected to each other preferably in such manner that one 2-(1-pyrazolyl)pyridine derivative is connected, at 6-position of the pyridine ring and/or 4-position of the 1-pyrazolyl group thereof, to the other 2-(1-pyrazolyl)pyridine derivative at 6-position of the pyridine ring and/or 4-position of the 1-pyrazolyl group thereof; more preferably in such manner that the two 2-(1-pyrazolyl)pyridine derivatives are connected to each other each at 6-position of the pyridine ring thereof or each at 4-position of the 1-pyrazolyl group thereof; and particularly preferably in such manner that the two 2-(1-pyrazolyl)pyridine derivatives are connected to each other each at 6-position of the pyridine ring thereof.

In the case where the ligand contains 1-arylpyrazole derivatives as a partial structure thereof, the 1-arylpyrazole derivatives are connected to each other preferably in such manner that one 1-arylpyrazole derivative is connected, at 3-position of the pyrazole ring and/or meta-position of the aryl group with respect to the pyrazole ring thereof, to the other 1-arylpyrazole derivative at 3-position of the pyrazole ring and/or meta-position of the aryl group with respect to the pyrazole ring thereof; more preferably in such manner that the two 1-arylpyrazole derivatives are connected to each other each at 3-position of the pyrazole ring thereof or each at meta-position of the aryl group with respect to the pyrazole ring thereof; and particularly preferably in such manner that the two 1-arylpyrazole derivatives are connected to each other each at 3-position of the pyrazole ring thereof.

The structure linking the partial structures of the ligand may be a single bond or a divalent linking bond, with a divalent linking bond being preferred. The divalent linking group is preferably a linking group of methylene, a linking group of ethylene, a linking group of phenylene, a linking group of nitrogen atom, a linking group of oxygen atom, a linking group of sulfur atom, or a linking group of silicon atom, more preferably a linking group of methylene, a linking group of nitrogen atom, or a linking group of silicon atom, particularly preferably a linking group of methylene. Specific examples of the linking group of methylene include a methylene group (-CH₂-), a methylmethylene group (-CHMe-), a fluoromethylmethylene group (-CFMe-), a dimethylmethylene group (-CMe₂-), a methylphenylmethylene group (-CMePh-), a diphenylmethylene group (-CPh₂-), a 9,9-fluorendiyl group, a 1,1-cyclopentandiyl group, and a 1,1-cyclohexandiyl group. Of these, a dimethylmethylene group, a diphenylmethylene group, a 9,9-fluorenandiyl group, a 1,1-cyclopentandiyl group, and a 1,1-cyclohexandiyl group are preferred, a dimethylmethylene group, a diphenylmethylene group, and a 1,1-cyclohexandiyl group are more preferred, and a dimethylmethylene group is particularly preferred.

Also, one of more preferred examples of the platinum complex phosphorescent material having a tetradentate ligand is a Pt complexe represented by the following formula (A).

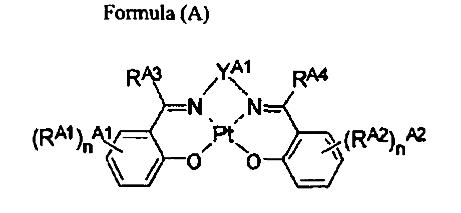

In the formula (A), R^{A3} and R^{A4} each independently represents a hydrogen atom or a substituent, and R^{A1} and R^{A2} each independently represents a substituent. In the case where plural R^{A1}s and R^{A2}s exist, they may be the same or different, or may be connected to each other to form a ring. n^{A1} and n^{A2} each independently represents an integer of from 0 to 4. Y^{A1} represents a linking group.

As substituents represented by R^{A1}, R^{A2}, R^{A3}, and R^{A4}, any one can be selected from the following substituent group A.

### Substituent group A:

An alkyl group (containing preferably from 1 to 30 carbon atoms, more preferably from 1 to 20 carbon atoms, particularly preferably from 1 to 10 carbon atoms; for example, a methyl group, an ethyl group, an iso-propyl group, a tert-butyl group, a n-octyl group, a n-decyl group, a n-hexadecyl group, a cyclopropyl group, a cyclopentyl group or a cyclohexyl group), an alkenyl group (containing preferably from 2 to 30 carbon atoms, more preferably from 2 to 20 carbon atoms, particularly preferably from 2 to 10 carbon atoms; for example, a vinyl group, an allyl group, a 2-butenyl group or a 3-pentenyl group); an alkynyl group (containing preferably from 2 to 30 carbon atoms, more preferably from 2 to 20 carbon atoms, particularly preferably from 2 to 10 carbon atoms; for example, a propargyl group or a 3-pentynyl group); an aryl group (containing preferably from 6 to 30 carbon atoms, more preferably from 6 to 20 carbon atoms, particularly preferably from 6 to 12 carbon atoms; for example, a phenyl group, a p-methylphenyl group, a naphthyl group or an anthranyl group), an amino group (containing preferably from 0 to 30 carbon atoms, more preferably from 0 to 20 carbon atoms, particularly preferably from 0 to 10 carbon atoms; for example, an amino group, a methylamino group, a dimethylamino group, a diethylamino group, a dibenzylamino group, a diphenylamino group or a ditolylamino group), an alkoxy group (containing preferably from 1 to 30 carbon atoms, more preferably from 1 to 20 carbon atoms, particularly preferably from 1 to 10 carbon atoms; for example, a methoxy group, an ethoxy group, a butoxy group or a 2-ethylhexyloxy group), an aryloxy group (containing preferably from 6 to 30 carbon atoms, more preferably from 6 to 20 carbon atoms, particularly preferably from 6 to 12 carbon atoms; for example, a phenyloxy group, a 1-naphthyloxy group or a 2-naphthyloxy group), a heterocyclic oxy group (containing preferably from 1 to 30 carbon atoms, more preferably from I to 20 carbon atoms, particularly preferably from 1 to 12 carbon atoms; for example, a pyridyloxy group, a pyrazyloxy group, a pyrimidyloxy group or a quinolyloxy group), an acyl group (containing preferably from 1 to 30 carbon atoms, more preferably from 1 to 20 carbon atoms, particularly preferably from 1 to 12 carbon atoms; for example, an acetyl group, a benzoyl group, a formyl group or a pivaloyl group), an alkoxycarbonyl group (containing preferably from 2 to 30 carbon atoms, more preferably from 2 to 20 carbon atoms, particularly preferably from 2 to 12 carbon atoms; for example, a methoxycarbonyl group or an ethoxycarbonyl group), an aryloxycarbonyl group (containing preferably from 7 to 30 carbon atoms, more preferably from 7 to 20 carbon atoms, particularly preferably from 7 to 12 carbon atoms; for example, a phenyloxycarbonyl), an acyloxy group (containing preferably from 2 to 30 carbon atoms, more preferably from 2 to 20 carbon atoms, particularly preferably from 2 to 10 carbon atoms; for example, an acetoxy group or a benzoyloxy group), an acylamino group (containing preferably from 2 to 30 carbon atoms, more preferably from 2 to 20 carbon atoms, particularly preferably from 2 to 10 carbon atoms; for example, an acetylamino group or a benzoylamino group), an alkoxycarbonylamino group (containing preferably from 2 to 30 carbon atoms, more preferably from 2 to 20 carbon atoms, particularly preferably from 2 to 12 carbon atoms; for example, a methoxycarbonylamino group), an aryloxycarbonylamino group (containing preferably from 7 to 30 carbon atoms, more preferably from 7 to 20 carbon atoms, particularly preferably from 7 to 12 carbon atoms; for example, a phenyloxycarbonylamino group), a sulfonylamino group (containing preferably from 1 to 30 carbon atoms, more preferably from 1 to 20 carbon atoms, particularly preferably from 1 to 12 carbon atoms; for example, a methanesulfonylamino group or a benzenesulfonylamino group), a sulfamoyl group (containing preferably from 0 to 30 carbon atoms, more preferably from 0 to 20 carbon atoms, particularly preferably from 0 to 12 carbon atoms; for example, a sulfamoyl group, a methylsulfamoyl group, a dimethylsulfamoyl group or a phenylsulfamoyl group), a carbamoyl group (containing preferably from 1 to 30 carbon atoms, more preferably from 1 to 20 carbon atoms, particularly preferably from 1 to 12 carbon atoms; for example, a carbamoyl group, a methylcarbamoyl group, a diethylcarbamoyl group or a phenylcarbamoyl group), an alkylthio group (containing preferably from 1 to 30 carbon atoms, more preferably from 1 to 20 carbon atoms, particularly preferably from 1 to 12 carbon atoms; for example, a methylthio group or an ethylthio group), an arylthio group (containing preferably from 6 to 30 carbon atoms, more preferably from 6 to 20 carbon atoms, particularly preferably from 6 to 12 carbon atoms; for example, a phenylthio group), a heterocyclic thio group (containing preferably from 1 to 30 carbon atoms, more preferably from 1 to 20 carbon atoms, particularly preferably from 1 to 12 carbon atoms; for example, a pyridylthio group, a 2-benzimidazolylthio group, a 2-benzoxazolylthio group or a 2-benzothiazolylthio group), a sulfonyl group (containing preferably from 1 to 30 carbon atoms, more preferably from 1 to 20 carbon atoms, particularly preferably from 1 to 12 carbon atoms; for example, a mesyl group or a tosyl group), a sulfinyl group (containing preferably from 1 to 30 carbon atoms, more preferably from 1 to 20 carbon atoms, particularly preferably from 1 to 12 carbon atoms; for example, a methanesulfinyl group or a benzenesulfinyl group), a ureido group (containing preferably from 1 to 30 carbon atoms, more preferably from 1 to 20 carbon atoms, particularly preferably from 1 to 12 carbon atoms; for example, a ureido group, a methylureido group or a phenylureido group), a phosphoric acid amide group (containing preferably from 1 to 30 carbon atoms, more preferably from 1 to 20 carbon atoms, particularly preferably from 1 to 12 carbon atoms; for example, a diethylphosphoric acid amide group or a phenylphosphoric acid amide group), a hydroxyl group, a mercapto group, a halogen atom (for example, a fluorine atom, a chlorine atom, a bromine atom or an iodine atom), a cyano group, a sulfo group, a carboxyl group, a nitro group, a hydroxamic acid group, a sulfino group, a hydrazino group, an imino group, a heterocyclic group (containing preferably from 1 to 30 carbon atoms, more preferably from 1 to 12 carbon atoms; hetero atom being, for example, nitrogen atom, oxygen atom or sulfur atom; specific examples including an imidazolyl group, a pyridyl group, a quinolyl group, a furyl group, a thienyl group, a piperidyl group, a morpholino group, a benzoxazolyl group, a benzimidazolyl group, a benzothiazolyl group, a carbazolyl group or an azepinyl group), a silyl group (containing preferably from 3 to 40 carbon atoms, more preferably from 3 to 30 carbon atoms, particularly preferably from 3 to 24 carbon atoms; for example, a trimethylsilyl group or a triphenylsilyl group), a silyloxy group (containing preferably from 3 to 40 carbon atoms, more preferably from 3 to 30 carbon atoms, particularly preferably from 3 to 24 carbon atoms; for example, a trimethylsilyloxy group or a triphenylsilyloxy group), and a phosphoryl group (for example, a diphenylphosphoryl group or a dimethylphosphoryl group).

As the linking group represented by Y^{A1}, any one can be selected from the following group A of the linking group.

### Group A of the linking group:

An alkylene group (for example, methylene, ethylene or propylene), an arylene group (for example, phenylene or naphthalenediyl), a hetero arylene group (for example, pyridinediyl or thiophenediyl), an imino group (-NR-) (for example, a phenylimino group), an oxy group (-O-), a thio group (-S-), a phosphinidene group (-PR-) (for example, a phenylphosphinidene group), a silylene group (-SiRR'-) (for example, a dimethylsilylene group or a diphenylsilylene group), and a combination thereof. These linking groups may further have a substituent.

As substituents represented by R^{A1}, R^{A2}, R^{A3}, and R^{A4}, an alkyl group, an aryl group, and a heterocyclic group are preferred, an aryl group and a heterocyclic group are more preferred, and an aryl group is particularly preferred.

As the linking group represented by Y^{A1}, a vinyl group, phenylene ring, a pyridine ring, pyrazine ring, or pyrimidine ring which are connected to the nitrogen atoms at 1- and 2-positions thereof, or an alkylene group containing from 1 to 8 carbon atoms is preferred, a vinyl group or phenylene ring which are connected to the nitrogen atoms at 1 and 2-positions thereof, or an alkylene group containing from I to 6 carbon atoms is more preferred, and a phenylene ring is particularly preferred.

The substituents represented by R^{A3} and R^{A4} may be connected to the linking group represented by Y^{A1} to form a ring. For example, in the case where Y^{A1} represents a phenylene group connected to the nitrogen atoms at 1- and 2-positions thereof. R^{A3} and R^{A4} may respectively be connected to 3- and 6-positions of the phenylene group to form a phenanthroline ring and may further have a substituent.

One of more preferred examples of the platinum complex phosphorescent material having a tetradentate ligand is a Pt complexe represented by the following formula (B).

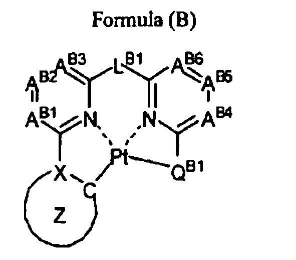

In the formula (B), A^{B1} to A^{B6} each independently represents C-R or N. R represents a hydrogen atom or a substituent. L^{B1} represents a divalent linking group. X represents C or N. Z represents a 5- or 6-membered aromatic or heteroaromatic ring formed together with X-C. Q^{B1} represents an anionic group connected to Pt.

The formula (B) will be described below.

A^{B1} to A^{B6} each independently represents C-R or N. R represents a hydrogen atom or a substituent. The Substituent represented by R is the same as those which have been illustrated as the foregoing substituent group A, and a preferred scope thereof is also the same as described there.

A^{B1} to A^{B6} each is preferably C-R, and Rs may be connected to each other to form a ring. In the case where A^{B1} to A^{B6} each represents C-R, R in each of A^{B2} and A^{B5} is preferably a hydrogen atom, an alkyl group, an aryl group, an amino group, an alkoxy group, an aryloxy group, a fluorine atom or a cyano group; more preferably a hydrogen atom, an amino group, an alkoxy group, an aryloxy group or a fluorine atom; and particularly preferably a hydrogen atom or a fluorine atom, and R in each of A^{B1}, A^{B3}, A^{B4}, and A^{B6} is preferably a hydrogen atom, an alkyl group, an aryl group, an amino group, an alkoxy group, an aryloxy group, a fluorine atom or a cyano group; more preferably a hydrogen atom, an amino group, an alkoxy group, an aryloxy group or a fluorine atom; and particularly preferably a hydrogen atom.

L^{B1} represents a single bond or a divalent linking group.

Examples of the divalent linking group represented by L^{B1} include an alkylene group (e.g., methylene, ethylene or propylene), an arylene group (e.g., phenylene or naphthalenediyl), a heteroarylene group (e.g., pyridinediyl or thiophenediyl), an imino group (-NR-) (e.g., a phenylimino group), an oxy group (-O-), a thio group (-S-), a phosphinidene group (-PR-) (e-g-, a phenylphosphinidene group), a silylene group (-SiRR'-) (e.g., a dimethylsilylene group or a diphenylsilylene group), and a combination thereof. These linking groups may further have a substituent.

L^{B1} represents preferably a single bond, an alkylene group, an arylene group, a heteroarylene group, an imino group, an oxy group, a thio group or a silylene group; more preferably a single bond, an alkylene group, an arylene group or an imino group; still more preferably an alkylene group; still more preferably a methylene group; still more preferably a di-substituted methylene group; still more preferably a dimethylmethylene group, a diethylmethylene group, a diisobutylmethylene group, a dibenzylmethylene group, an ethylmethylmethylene group, a methylpropylmethylene group, an isobutylmethylmethylene group, a diphenylmethylene group, a methylphenylmethylene group, a cyclohexanediyl group, a cyclopentanediyl group, a fluorenediyl group or a fluoromethylmethylene group; and particularly preferably a dimethylmethylene group, a diphenylmethylene group or a cyclohexanediyl group.

X represents C or N. Z represents a 5- or 6-membered aromatic hydrocarbon romg or heteroaromatic ring formed together with X-C. Examples of the aromatic hydrocarbon ring or heteroammatic ring represented by Z include a benzene ring, a naphthalene ring, an anthracene ring, a pyrene ring, a phenanthrene ring, a perylene ring, a pyridine ring, a quinoline ring, an isoquinoline ring, a phenanthridine ring, a pyrimidien ring, a pyrazine ring, a pyridazine ring, a triazine ring, cinnoline ring, an acridine ring, a phthalazine ring, a quinazoline ring, a quinoxaline ring, a naphthyridine ring, a pteridine ring, a pyrrole ring, a pyrazole ring, a triazole ring, an indole ring, a carbazole ring, an indazole ring, a benzimidazole ring, an oxazole ring, a thiazole ring, an oxadiazole ring, a thiadiazole ring, a benzoxazole ring, a benzothiazole ring, an imidazopyridine ring, a thiophene ring, a benzothiophene ring, a furan ring, a benzofuran ring, a phosphole ring, a phosphinine ring, and a silole ring. Z may contain a substituent. As the substituent, those which have heretofore been illustrated as the substituent group A may be applied. In addition, Z may form a condensed ring together with other ring.

Z is preferably a benzene ring, a naphthalene ring, a pyrazole ring, an imidazole ring, a triazole ring, a pyridine ring, an indole ring or a thiophene ring, more preferably a benzene ring, a pyrazole ring or a pyridine ring.

Q^{B1} represents an anionic group connected to Pt. Examples of the anionic group represented by Q^{B1} include a vinyl ligand, an aromatic hydrocarbon ring ligand (e.g., a benzene ligand, a naphthalene ligand, an anthracene ligand or a phenanthrene ligand), a heterocyclic ligands (e.g., a furan ligand, a thiophene ligand, a pyridine ligand, a pyrazine ligand, a pyrimidine ligand, a pyridazine ligand, a triazine ligand, a thiazole ligand, an oxazole ligand, a pyrrole ligand, an imidazole ligand, a pyrazole ligand, a triazole ligand, and a ring-condensed ligand thereof (e.g., a quinoline ligand or a benzothiazole ligand). In this case, the bond between Pt and Q^{B1} may be any of covalent bond, ionic bond and coordination bond. As the atom in Q^{B1} connected to Pt, a carbon atom, a nitrogen atom, an oxygen atom, a sulfur atom, and a phosphorus atom are preferred, a carbon atom, an oxygen atom, and a nitrogen atom are more preferred, and a carbon atom is still more preferred.

The group represented by Q^{B1} is preferably an aromatic hydrocarbon ring ligand connected to Pt at the carbon atom thereof, an aromatic heterocyclic ligand connected to Pt at the carbon atom thereof, a nitrogen-containing aromatic heterocyclic ligand connected to Pt at the nitrogen atom thereof, or an acyloxy ligand, more preferably an aromatic hydrocarbon ring ligand connected to Pt at the carbon atom thereof, or an aromatic heterocyclic ligand connected to Pt at the carbon atom thereof. It is particularly preferred that the group represented by Q^{B1} is the same group as Z ring formed together with C-X in the formula (B).

The Pt complex represented by the formula (B) is more preferably a Pt complex represented by the following formula (C).

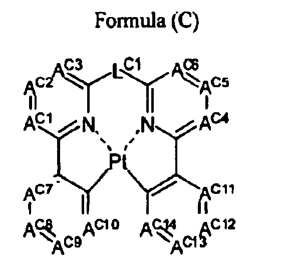

In the formula (C), A^{C1} to A^{C14} each independently represents C-R or N. R represents a hydrogen atom or a substituent. L^{C1} represents a single bond or a divalent linking group.

The formula (C) will be described below.

A^{C1} to A^{C14} each independently represents C-R or N. R represents a hydrogen atom or a substituent. A^{C1} to A^{C6} are the same as A^{B1} to A^{B6} in the foregoing formula (B), and a preferred scope thereof are also the same as described there.

Regarding A^{C7} to A^{C14}, the number of N (nitrogen atom) among A^{C7} to A^{C10} and the number of N among A^{C11} to A^{C14} each is preferably from 0 to 2, more preferably from 0 to 1. Members representing N are selected from among A^{C8} to A^{C10} and among A^{C12} to A^{C14}, more preferably from among A^{C8}, A^{C9}, A^{C12}, and A^{C13}, particularly preferably from among A^{C8} and A^{C12}.

In the case where A^{C7} to A^{C14} each represents C-R, R in each of A^{C8} and A^{C12} is preferably a hydrogen atom, an alkyl group, a polyfluoroalkyl group, an aryl group, an amino group, an alkoxy group, an aryloxy group, a fluorine atom or a cyano group; more preferably a hydrogen atom, a polyfluoroalkyl group, an alkyl group, an aryl group, a fluorine atom or a cyano group; and particularly preferably a hydrogen atom, a polyfluoroalkyl group or a cyano group. R in each of A^{C7}, A^{C9}, A^{C11}, and A^{C13} is preferably a hydrogen atom, an alkyl group, a polyfluoroalkyl group, an aryl group, an amino group, an alkoxy group, an aryloxy group, a fluorine atom or a cyano group; more preferably a hydrogen atom, a polyfluoroalkyl group, a fluorine atom or a cyano group; and particularly preferably a hydrogen atom or a fluorine atom. R in each of by A^{C7} and A^{C9} is preferably a hydrogen atom or a fluorine atom, more preferably a hydrogen atom. In the case where any two of A^{C7} to A^{C9} and A^{C11} to A^{C13} represent C-R, Rs may be connected to each other to form a ring.

The linking group represented by L^{C1} is the same as the linking group represented by L^{B1} in the foregoing formula (B), and a preferred scope thereof is also the same as described there.

The Pt complex represented by the formula (B) is more preferably a Pt complex represented by the following formula (D).

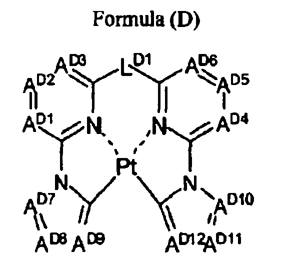

In the formula (D), A^{D1} to A^{D12} each independently represents C-R or N. R represents a hydrogen atom or a substituent. L^{D1} represents a single bond or a divalent linking group.

The formula (D) will be described below.

A^{D1} to A^{D12} each independently represents C-R or N. R represents a hydrogen atom or a substituent.

A^{D1} to A^{D6} are the same as A^{B1} to A^{B6} in the foregoing formula (B), and a preferred scope thereof is also the same as described there.

Regarding A^{D7} to A^{D12}, the number of N (nitrogen atom) among A^{D7} to A^{D9} and the number ofN among A^{D10} to A^{D12} each is preferably from 0 to 2, more preferably from 0 to 1, particularly preferably 1. Members representing N are selected from among A^{D7} to A^{D9} and among A^{D10} to A^{D12}, more preferably from among A^{D7}, A^{D9}, A^{D10}, and A^{D12}, particularly preferably from among A^{D7} and A^{D10}.

In the case where A^{D7} to A^{D12} each represents C-R, R represented by AD⁸ and A^{D11} is preferably a hydrogen atom, an alkyl group, a polyfluoroalkyl group, an aryl group, an amino group, an alkoxy group, an aryloxy group, a fluorine atom or a cyano group; more preferably a hydrogen atom, a polyfluoroalkyl group, an alkyl group, an aryl group, a fluorine atom or a cyano group; and particularly preferably a polyfluoroalkyl group (e.g., a trifluoromethyl group or a perfluoroethyl group) or a cyano group. R in each of A^{D7}, A^{D9}, A^{D10}, and A^{D12} is preferably a hydrogen atom, an alkyl group, a polyfluoroalkyl group, an aryl group, an amino group, an alkoxy group, an aryloxy group, a fluorine atom or a cyano group; more preferably a hydrogen atom, a hydrogen atom or a fluorine atom; and particularly preferably a hydrogen atom. In the case where any two of A^{D7} to A^{D12} represent C-R, Rs may be connected to each other to form a ring.

The linking group represented by L^{D1} is the same as the linking group represented by L^{B1} in the foregoing formula (B), and a preferred scope thereof is also the same as described there.

One of more preferred examples of the platinum complex phosphorescent material having a tetradentate ligand is a Pt complex represented by the following formula (E).

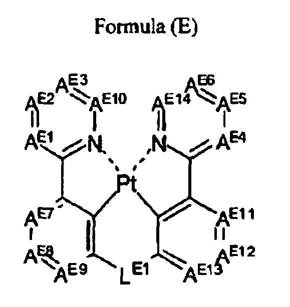

In the formula (E), A^{E1} to A^{E14} each independently represents C-R or N. R represents a hydrogen atom or a substituent. L^{E1} represents a single bond or a divalent linking group.

The formula (E) will be described below.

A^{E1} to A^{E12} each independently represents C-R or N. R represents a hydrogen atom or a substituent. A^{E1} to A^{E6} are the same as A^{B1} to A^{B6} in the foregoing formula (B), and a preferred scope thereof is also the same as described there. A^{E7} to A^{E14} are the same as A^{C7} to A^{C14} in the foregoing formula (C), and a preferred scope thereof is also the same as described there.

The linking group represented by L^{E1} is the same as the linking group represented by L^{B1} in the foregoing formula (B).

L^{B1} represents preferably a single bond, an alkylene group, an arylene group, a heteroarylene group, an imino group, an oxy group, a thio group or a silylene group; more preferably an alkylene group, an imino group, an oxy group, a thio group or a silylene group; still more preferably an alkylene group; still more preferably a methylene group; still more preferably a di-substituted methylene group; still more preferably a dimethylmethylene group, a diethylmethylene group, a diisobutylmethylene group, a dibenzylmethylene group, an ethylmethylmethylene group, a methylpropylmethylene group, an isobutylmethylmethylene group, a diphenylmethylene group, a methylphenylmethylene group, a cyclohexanediyl group, a cyclopentanediyl group, a fluorenediyl group or a fluoromethylmethylene group; and particularly preferably a dimethylmethylene group, a diphenylmethylene group or a cyclohexanediyl group.

One of more preferred examples of the platinum complex phosphorescent material having a tetradentate ligand is a Pt complex represented by the following formula (F).

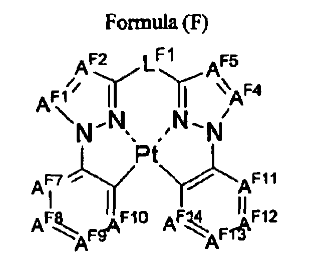

In the formula (F), A^{F1} to A^{F14} each independently represents C-R or N. R represents a hydrogen atom or a substituent. L^{F1} represents a single bond or a divalent linking group.

The formula (F) will be described below.

A^{F1} to A^{F14} each independently represents C-R or N. R represents a hydrogen atom or a substituent. A^{F1} to A^{F5} are the same as A^{B1} to A^{B5} in the foregoing formula (B). A^{F1} to A^{F5} each is preferably C-R, and Rs may be connected to each other to form a ring. In the case where A^{F1} to A^{F5} each is C-R, R in each of A^{F1} to A^{F5} is preferably a hydrogen atom, an alkyl group, an aryl group, an amino group, an alkoxy group, an aryloxy group, a fluorine atom or a cyano group; more preferably a hydrogen atom, an aryl group, a fluorine atom or a cyano group; particularly preferably a hydrogen atom.

A^{F7} to A^{F14} are the same as A^{C7} to A^{C14} in the foregoing formula (C), and a preferred scope thereof is also the same as described there. In particular, in the case where any two of A^{C7} to A^{C9} and A^{C11} to A^{C13} represent C-R, the ring structure formed by Rs connected to each other is preferably a furan ring, a benzofuran ring, a pyrrole ring, a benzopyrrole ring, a thiophene ring, a benzothiophene ring or a fluorine ring. These rings may further have a substituent.

The linking group represented by L^{F1} is the same as the linking group represented by L^{B1} in the foregoing formula (B), and a preferred scope thereof is also the same.

Specific examples of the light-emitting materials are illustrated below which, however, are not to be construed to limit the invention in any way.

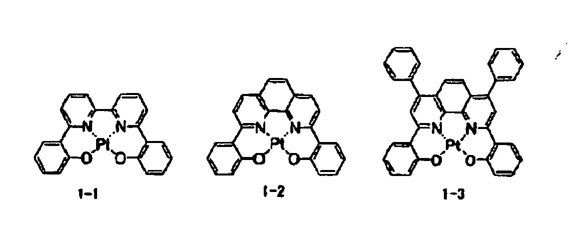

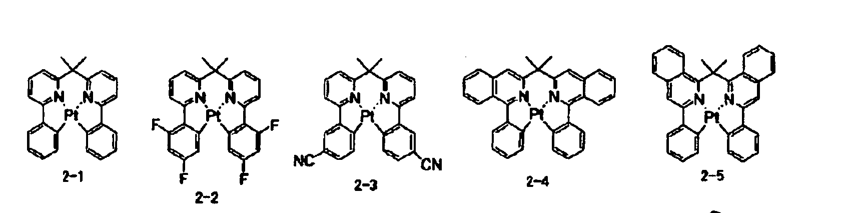

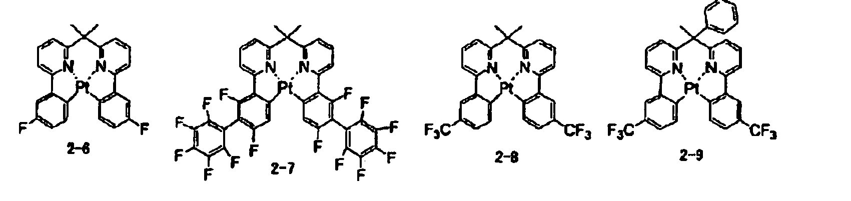

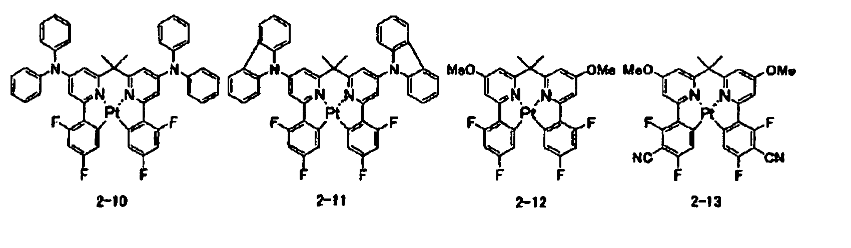

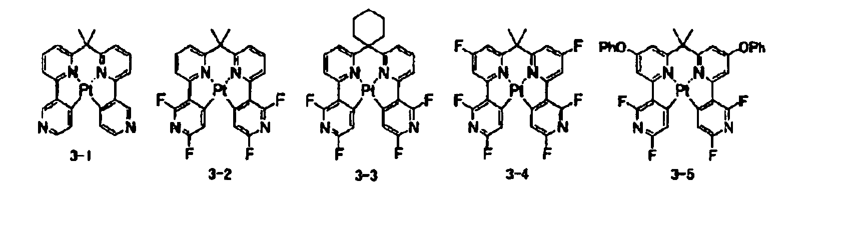

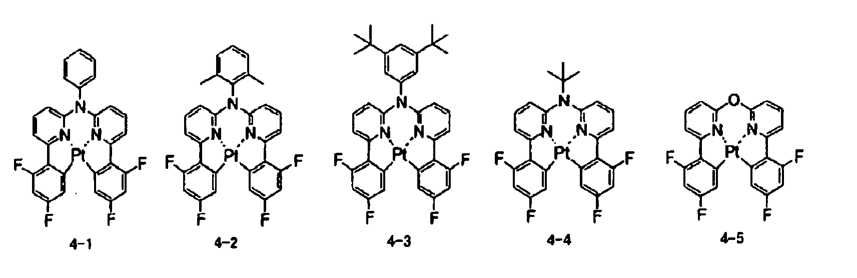

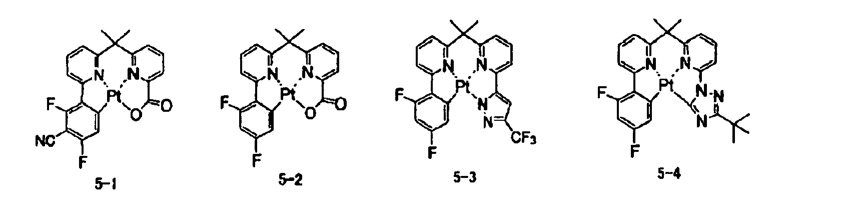

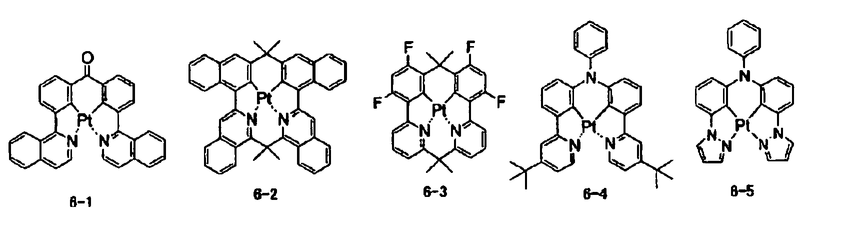

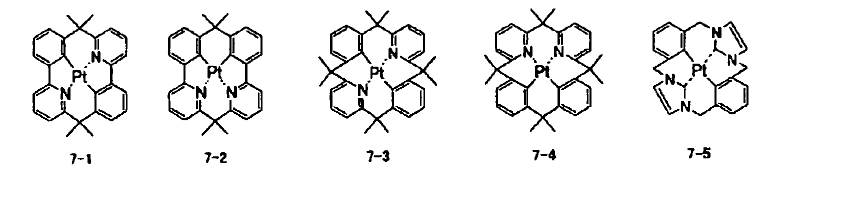

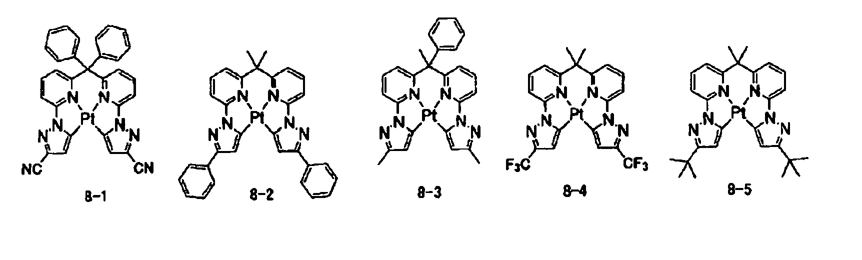

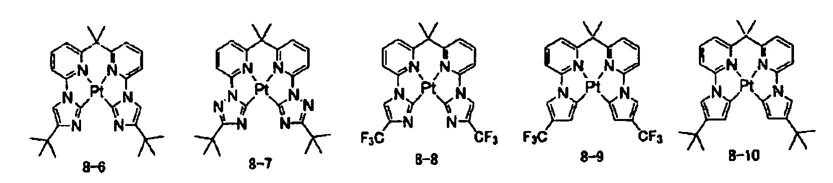

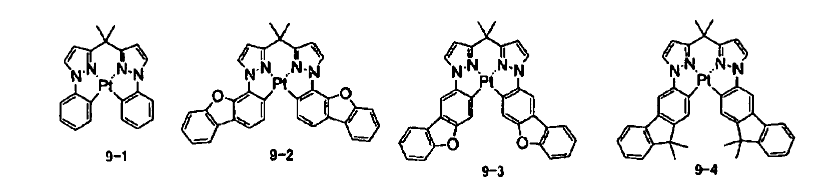

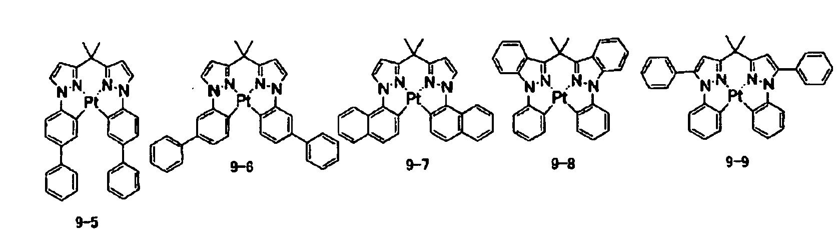

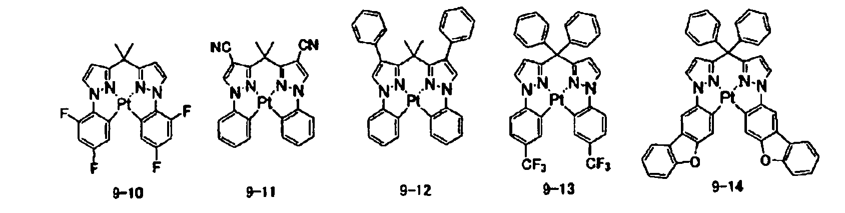

The above metal complex compounds can be synthesized by various methods. For example, the method described in G.R Newkome et al., Journal of Organic Chemistry, 53, 786 (1988), page 789, line 53 of left column to line 7 of right column, the method on page 790, lines 18 to 38 of left column, the method on page 790, lines 19 to 30 of right column, and combinations of these methods, H. Lexy et al., Chemische Berichte, 113, 2749 (1980), page 2752, lines 26 to 35, etc., can be used.

For example, these metal complex compounds can be obtained by heating (besides ordinary heating, a means of heating by microwave is also effective) a ligand or dissociated product thereof and a metal compound, or at room temperature or lower, in the presence of a solvent (e.g., halogen solvents, alcohol solvents, ether solvents, ester solvents, ketone solvents, nitrile solvents, amide solvents, sulfone solvents, sulfoxide solvents, and water are exemplified), or in the absence of a solvent, and in the presence of a base (various inorganic and organic bases, e.g., sodium methoxide, potassium t-butoxy, triethylamine, potassium carbonate are exemplified), or in the absence of a base.

In the invention, it is preferred for a platinum complex having a tetradentate ligand to be used as a light-emitting material.

A platinum complex having a tetradentate ligand is contained in a light-emitting layer generally in a proportion of from 0.1 to 50 mass% with respect to all the mass of the compounds forming the light-emitting layer, preferably from I to 50 mass% from the viewpoint of durability and external quantum efficiency, and more preferably from 2 to 40 mass%.

Each component constituting the device of the invention will be explained in detail below.

### Organic electroluminescent device:

A device of the invention will be described in detail below.

A light-emitting device in the invention includes a substrate having thereon a cathode and an anode, and an organic layer between the electrodes, the organic layer including a light-emitting layer (the organic layer may be organic layers containing an organic compound alone, or may be organic layers containing an inorganic compound in addition to the organic compound). Accordingly, an organic layer in the invention may be the constitution including a light-emitting layer alone. From the properties of the light-emitting device, it is preferred that at least one electrode of the cathode and anode is transparent.

As an embodiment of stacking of the organic layers in the invention, the stacking is preferably in order of a hole transporting layer, a light-emitting layer, and an electron transporting layer from the anode side. Further, a charge blocking layer may be provided between the hole transporting layer and the light-emitting layer, or between the light-emitting layer and the electron transporting layer. A hole injecting layer may be provided between the anode and the hole transporting layer, and an electron injecting layer may be provided between the cathode and the electron transporting layer. Each layer may be divided into a plurality of secondary layers.

Constituents of a light-emitting device of the invention are described in detail below. Substrate:

A substrate for use in the invention is preferably a substrate that does not scatter or attenuate the light emitted from the organic layer. The specific examples of the materials of the substrate include inorganic materials, e.g., yttria stabilized zirconia (YSZ), glass, etc., and organic materials, such as polyester, e.g., polyethylene terephthalate, polybutylene phthalate, polyethylene naphthalate, etc., polystyrene, polycarbonate, polyether sulfone, polyallylate, polyimide, polycycloolefin, norbornene resin, poly(chloro- trifluoroethylene), etc.

When glass is used as a substrate, non-alkali glass is preferably used as the material for reducing elution of ions from the glass. Further, when soda lime glass is used, it is preferred to provide a barrier coat such as silica. In the case of organic materials, materials excellent in heat resistance, dimensional stability, solvent resistance, electrical insulating properties and processability are preferably used.

The form, structure and size of a substrate are not especially restricted, and these can be arbitrarily selected in accordance with the intended use and purpose of the light-emitting device. In general, a substrate is preferably in a plate-like form. The structure of a substrate may be a single layer structure or may be a layered structure, and may consist of a single member or may be formed of two or more members.

A substrate may be colorless and transparent, or may be colored and transparent, but from the point of not scattering or attenuating the light emitted from the light-emitting layer, a colorless and transparent substrate is preferably used.

A substrate can be provided with a moisture permeation preventing layer (a gas barrier layer) on the front surface or rear surface.

As the materials of the moisture permeation preventing layer (the gas barrier layer), inorganic materials such as silicon nitride and silicon oxide are preferably used. The moisture permeation preventing layer (the gas barrier layer) can be formed, for example, by a high frequency sputtering method.

When a thermoplastic substrate is used, if necessary, a hard coat layer and an undercoat layer may further be provided.

### Anode:

An anode is generally sufficient to have the function of the electrode to supply holes to an organic layer. The form, structure and size of an anode are not especially restricted, and these can be arbitrarily selected from known materials of electrode in accordance with the intended use and purpose of the light-emitting device. As described above, an anode is generally provided as a transparent anode.

As the materials of anode, for example, metals, alloys, metal oxides, electrically conductive compounds, and mixtures of these materials are preferably exemplified. The specific examples of the materials of anode include electrically conductive metal oxides, e.g., tin oxide doped with antimony or fluorine (ATO, FTO), tin oxide, zinc oxide, indium oxide, indium tin oxide (ITO), indium zinc oxide (IZO), etc., metals, e.g., gold, silver, chromium, nickel, etc., mixtures or layered products of these metals with electrically conductive metal oxides, inorganic electrically conductive substances, e.g., copper iodide, copper sulfide, etc., organic electrically conductive materials, e.g., polyaniline, polythiophene, polypyrrole, etc., layered products of these materials with ITO, etc. Of these materials, electrically conductive metal oxides are preferred, and ITO is especially preferred in view of productivity, high conductivity, transparency and the like.

An anode can be formed on the substrate in accordance with various methods arbitrarily selected from, for example, wet methods, e.g., a printing method, a coating method, etc., physical methods, e.g., a vacuum deposition method, a sputtering method, an ion plating method, etc., and chemical methods, e.g., a CVD method, a plasma CVD method, etc., taking the suitability with the material to be used in the anode into consideration. For example, in the case of selecting ITO as the material of an anode, the anode can be formed according to a direct current or high frequency sputtering method, a vacuum deposition method, an ion plating method, etc.

In a device of the invention, the position of the anode to be formed is not especially restricted and can be formed anywhere. The position can be arbitrarily selected in accordance with the intended use and purpose of the light-emitting device, but preferably provided on the substrate. In this case, the anode may be formed on the entire surface of one side of the substrate, or may be formed on a part of the organic layer.

As patterning in forming an anode, patterning may be performed by chemical etching such as by photo-lithography, may be carried out by physical etching such as by laser, may be performed by vacuum deposition or sputtering on a superposed mask, or a lift-off method and a printing method may be used.

The thickness of an anode can be optionally selected in accordance with the materials of the anode, so that cannot be regulated unconditionally, but the thickness is generally from 10 nm to 50 µm or so, and is preferably from 50 nm to 20 µm.

The value of resistance of an anode is preferably 10³ Ω/□ or less, and more preferably 10² Ω/□ or less. In the case where an anode is transparent, the anode may be colorless and transparent, or colored and transparent. For the coupling out of luminescence from the transparent anode side, the transmittance is preferably 60% or more, and more preferably 70% or more.

In connection with transparent anodes, description is found in Yutaka Sawada supervised, Tomei Denkyoku-Maku no Shintenkai (New Development in Transparent Electrode Films), CMC Publishing Co., Ltd. (1999), and the description therein can be referred to. In the case of using a plastic substrate low in heat resistance, a transparent anode film-formed with ITO or IZO at a low temperature of 150°C or less is preferred.

### Cathode:

A cathode is generally sufficient to have the function of the electrode to supply electrons to an organic layer. The form, structure and size of a cathode are not especially restricted, and these can be arbitrarily selected from known materials of electrode in accordance with the intended use and purpose of the light-emitting device.

As the materials of cathode, for example, metals, alloys, metal oxides, electrically conductive compounds, and mixtures of these materials are exemplified. The specific examples of the materials of cathode include alkali metals (e.g., Li, Na, K, Cs, etc.), alkaline earth metals (e.g., Mg, Ca, etc.), gold, silver, lead, aluminum, sodium-potassium alloy, lithium-aluminum alloy, magnesium-silver alloy, indium, rare earth metals, e.g., ytterbium, etc. These materials may be used by one kind alone, but from the viewpoint of the compatibility of stability and an electron injecting property, two or more kinds of materials are preferably used in combination.

As the materials constituting a cathode, alkali metals and alkaline earth metals are preferred of these materials in the point of electron injection, and materials mainly including aluminum are preferred for their excellent preservation stability.

The materials mainly including aluminum mean aluminum alone, alloys of aluminum with 0.01 to 10 mass% of alkali metal or alkaline earth metal, or mixtures of these (e.g., lithium-aluminum alloy, magnesium-aluminum alloy, etc.).

The materials of cathode are disclosed in JP-A-2-15595 and JP-A-5-121172, and the materials described in these patents can also be used in the invention.

A cathode can be formed by known methods with no particular restriction. For example, a cathode can be formed according to wet methods, e.g., a printing method, a coating method, etc., physical methods, e.g., a vacuum deposition method, a sputtering method, an ion plating method, etc., and chemical methods, e.g., a CVD method, a plasma CVD method, etc., taking the suitability with the material constituting the cathode into consideration. For example, in the case of selecting metals as the material of a cathode, the cathode can be formed with one or two or more kinds of materials at the same time or in order by sputtering, etc.

As patterning in forming a cathode, patterning may be performed by chemical etching such as by photo-lithography, may be carried out by physical etching such as by laser, may be performed by vacuum deposition or sputtering on a superposed mask, or a lift-off method and a printing method may be used.

The position of the cathode to be formed is not especially restricted and can be formed anywhere in the invention. The cathode may be formed on the entire surface of the organic layer, or may be formed on a part of the organic layer.

A dielectric layer including fluoride or oxide of alkali metal or alkaline earth metal may be inserted between the cathode and the organic layer in a thickness of from 0.1 to 5 nm. The dielectric layer can be regarded as one kind of an electron injecting layer. The dielectric layer can be formed, for example, according to a vacuum deposition method, a sputtering method, an ion plating method, etc.

The thickness of a cathode can be optionally selected in accordance with the materials of the cathode, so that cannot be regulated unconditionally, but the thickness is generally from 10 nm to 5 µm or so, and is preferably from 50 nm to 1 µm.

A cathode may be transparent or opaque. A transparent cathode can be formed by forming a thin film of the materials of the cathode in a thickness of from 1 to 10 nm, and further stacking transparent conductive materials such as ITO and IZO.

### Organic layer:

Organic layers in the invention will be described below.

A device of the invention has at least one organic layer including a light-emitting layer. As organic layers other than the light-emitting layer, as described above, a hole transporting layer, an electron transporting layer, a charge blocking layer, a hole injecting layer and an electron injecting layer are exemplified.

### Formation of organic layers:

In a device of the invention, each layer constituting organic layers can be preferably formed by any of dry film-forming methods such as a vacuum deposition method, a sputtering method, etc., a transfer method, and a printing method.

### Light-emitting layer:

The light-emitting layer is a layer having functions to receive, at the time of applying an electric field, holes from the anode, hole injecting layer or hole transporting layer, and electrons from the cathode, electron injecting layer or electron transporting layer, and to offer the field of recombination of holes and electrons to emit light. A light-emitting layer may include one layer alone or two or more layers, and in the case of two or more layers, each layer may emit light of color different from other layers.

A light-emitting layer in the invention may consist of light-emitting materials alone, or may comprise a mixed layer of a host material and a light-emitting material.

The term "host material" as used herein means a material constituting the light-emitting layer excluding light-emitting materials and having at least one function among a function of dispersing light-emitting materials to hold them in the light-emitting layer, a function of receiving a hole from anode or from a hole transporting layer, a function of receiving an electron from cathode or from an electron transporting layer, a function of transporting a hole and/or an electron, a function of providing a site for recombination of hole and electron, a function of transferring energy of exciton generated by the recombination to a light-emitting material, and a function of transporting a hole and/or an electron to a light-emitting material.

The host material is preferably a charge transporting material, and one or two or more host materials may be used. For example, the constitution of the mixture of an electron transporting host material and a hole transporting host material is exemplified. Further, a material not having an electron transporting property and not emitting luminescence may be contained in the light-emitting layer.

As host materials to be contained in a light-emitting layer of the invention, e.g., materials having a carbazole skeleton, having a diarylamine skeleton, having a pyridine skeleton, having a pyrazine skeleton, having a triazine skeleton, and having an arylsilane skeleton, and those described later in the items of a hole injecting layer, a hole transporting layer, an electron injecting layer, and an electron transporting layer are exemplified.

As light-emitting materials, other than the above-mentioned platinum complex having a tetradentate ligand, a fluorescent material and/or a phosphorescent material can be used.

### Fluorescent material:

The examples of fluorescent materials generally include various metal complexes represented by metal complexes of bcnzoxazole, benzimidazole, benzothiazole, styrylbenzene, polyphenyl, diphenylbutadiene, tetraphenylbutadiene, naphthalimide, coumarin, pyrane, perinone, oxadiazole, aldazine, pyridine, cyclopentadiene, bisstyrylanthracene, quinacridone, pyrrolopyridine, thiadiazolopyridine, styrlamine, aromatic dimethylidyne compounds, condensed aromatic compounds (e.g., anthracene, phenanthroline, pyrene, perylene, rubrene, and pentacene), and 8-quinolinol, pyrromethene complexes, and rare earth complexes; polymer compounds such as polythiophene, polyphenylene, polyphenylenevinylene; organic silane; and derivatives thereof.

### Phosphorescent material:

The examples of phosphorescent materials generally include complexes containing a transition metal atom or a lanthanoid atom.

The transition metal atoms are not especially restricted, but ruthenium, rhodium, palladium, tungsten, rhenium, osmium, indium, gold, silver, copper, and platinum are preferably exemplified; rhenium, iridium and platinum are more preferred, and iridium and platinum are still more preferred.

As lanthanoid atoms, lanthanum, cerium, praseodymium, neodymium, samarium, europium, gadolinium, terbium, dysprosium, holmium, erbium, thulium, ytterbium, and lutecium are exemplified. Of these lanthanoid atoms, neodymium, europium and gadolinium are preferred.

As the examples of ligands of complexes, the ligands described, for example, in G. Wilkinson et al., Comprehensive Coordination Chemistry, Pergamon Press (1987), H. Yersin, Photochemistry and Photophysics of Coordination Compounds, Springer-Verlag (1987), and Akio Yamamoto, Yuki Kinzoku Kagaku -Kiso to Oyo- (Organic Metal Chemistry -Elements and Applications), Shokabo Publishing Co. (1982) are exemplified.

As the specific ligands, the preferred are halogen ligands (preferably a chlorine ligand), nitrogen-containing heterocyclic ligands (e.g., phenylpyridine, benzoquinoline, quinolinol, bipyridyl, phenanthroline, etc.), diketone ligands (e.g., acetylacetone, etc.), carboxylic acid ligands (e.g., an acetic acid ligand, etc.), carbon monoxide ligands, isonitrile ligands, and cyano ligands are exemplified, and the more preferred are nitrogen-containing heterocyclic ligands. The complex may have one transition metal atom in the compound, or may be what is called a polynuclear complex having two or more. Different kinds of metal atoms may be contained at the same time.

As the specific examples of the light-emitting materials capable of being used in combination with the platinum complex phosphorescent materials, the following compounds are exemplified, for example, but the invention is not restricted to these compounds.

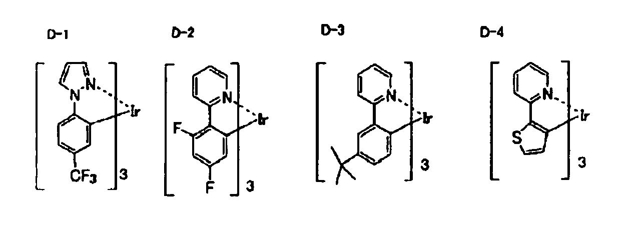

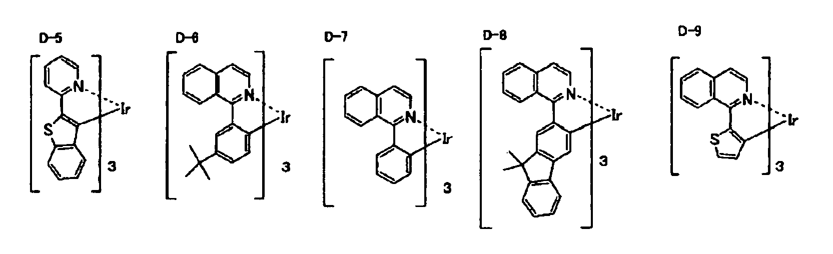

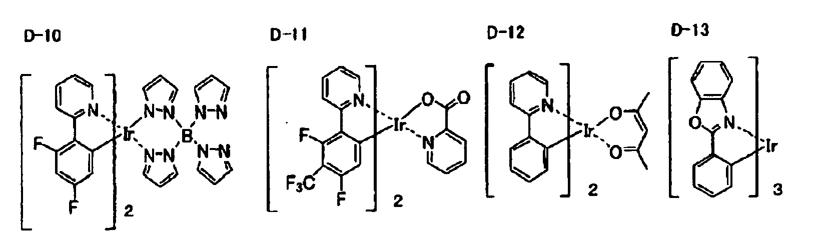

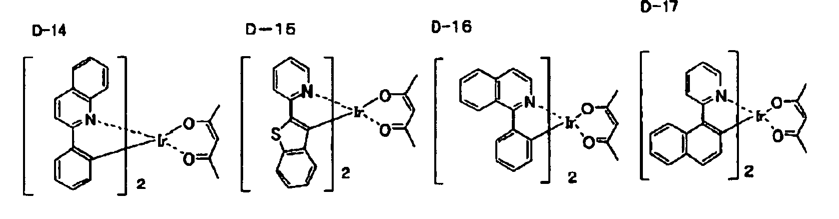

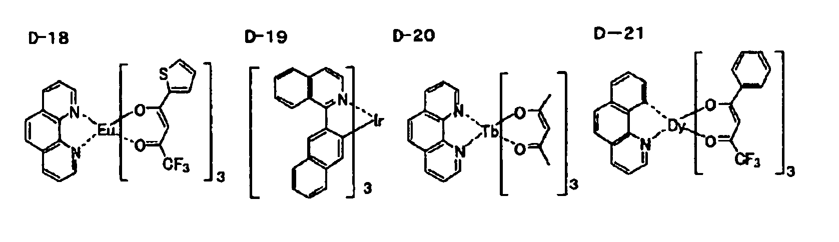

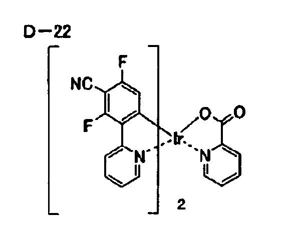

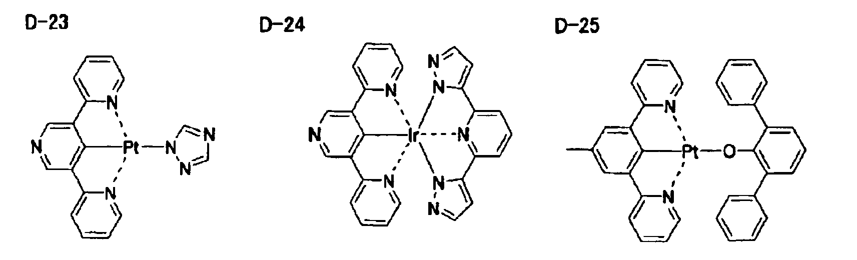

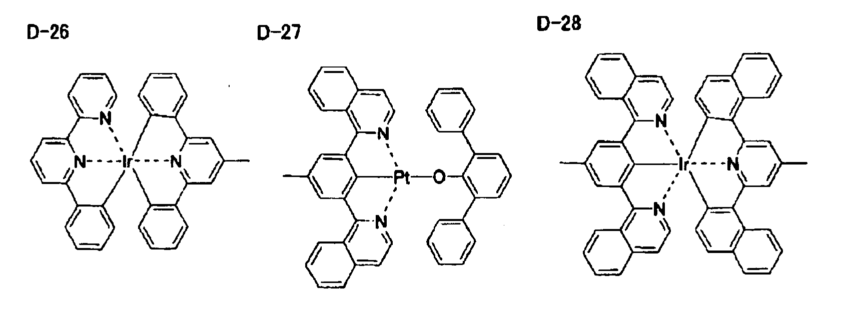

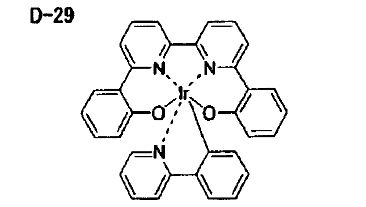

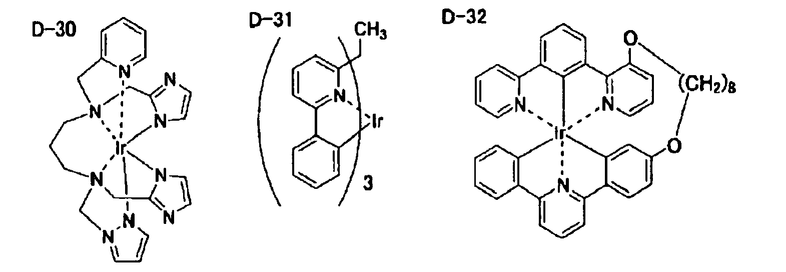

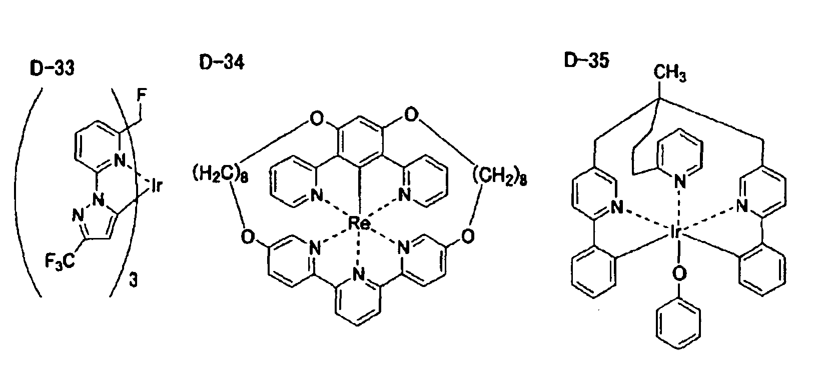

The light-emitting material is incorporated in the light-emitting layer in an amount of generally from 0.1 to 50% by weight with respect to the weight of all the compounds forming the light-emitting layer and, in view of durability and external quantum efficiency, in an amount of preferably from 1 to 50% by weight, more preferably from 2 to 40% by weight.

The thickness of the light-emitting layer is not especially limited, but is generally preferably from 1 to 500 nm, more preferably from 5 to 200 nm, and still more preferably from 10 to 100 nm.

### Hole injecting layer and hole transporting layer:

The hole injecting layer and the hole transporting layer are layers having a function to receive holes from the anode or anode side and transport the holes to the cathode side. The hole injecting layer and the hole transporting layer are specifically preferably the layers containing carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne compounds, porphyrin compounds, organic silane derivatives, carbon, and various kinds of metal complexes represented by Ir complex, having phenylazole, or phenylazine as the ligand.

The thickness of the hole injecting layer and hole transporting layer is preferably 500 nm or less from the viewpoint of lowering driving voltage.

The thickness of the hole transporting layer is preferably from 1 to 500 nm, more preferably from 5 to 200 nm, and still more preferably from 10 to 100 nm. The thickness of the hole injecting layer is preferably from 0.1 to 200 nm, more preferably from 0.5 to 100 nm, and still more preferably from 1 to 100 nm.

The hole injecting layer and the hole transporting layer may be a single layer structure including one or two or more of the above materials, or may be a multilayer including comprising a plurality of layers of the same or different compositions.

### Electron injecting layer and electron transporting layer:

The electron injecting layer and the electron transporting layer are layers having a function to receive electrons from the cathode or cathode side and transport the electrons to the anode side. The electron injecting layer and the electron transporting layer are specifically preferably layers containing triazole derivatives, oxazole derivatives, oxadiazole derivatives, imidazole derivatives, fluorenone derivatives, anthraquinodimethane derivatives, anthrone derivatives, diphenylquinone derivatives, thiopyran dioxide derivatives, carbodiimide derivatives, fluorenylidenemethane derivatives, distyrylpyrazine derivatives, tetracarboxylic anhydride of aromatic rings such as naphthalene, perylene, etc., a phthalocyanine derivative, various metal complexes represented by metal complexes of 8-quinolinol derivatives or metalphthalocyanine and metal complexes having benzoxazole, benzothiazole as the ligand, and organic silane derivative, etc.

The thickness of each of the electron injecting layer and electron transporting layer is preferably 500 nm or less from the viewpoint of lowering driving voltage.

The thickness of the electron transporting layer is preferably from 1 to 500 nm, more preferably from 5 to 200 nm, and still more preferably from 10 to 100 nm. The thickness of the electron injecting layer is preferably from 0.1 to 200 nm, more preferably from 0.2 to 100 nm, and still more preferably from 0.5 to 50 nm.

The electron injecting layer and the electron transporting layer may be a single layer structure comprising one or two or more of the above materials, or may be a multilayer structure comprising a plurality of layers of the same or different compositions.

### Hole blocking layer:

A hole blocking layer is a layer having a function of preventing holes transported from the anode side to the light-emitting layer from passing through to the cathode side. In the invention, a hole blocking layer can be provided as the organic layer contiguous to the light-emitting layer on the cathode side.

As the examples of the organic compounds constituting the hole blocking layer, aluminum complexes, e.g., BAlq, etc., triazole derivatives, phenanthroline derivatives, e.g., BCP, etc., can be exemplified.

The thickness of the hole blocking layer is preferably from 1 to 500 nm, more preferably from 5 to 200 nm, and still more preferably from 10 to 100 nm.

The hole blocking layer may be a single layer structure comprising one or two or more of the above materials, or may be a multilayer structure comprising a plurality of layers of the same or different compositions.

### Protective layer:

In the invention, an organic electroluminescent device may be completely protected with a protective layer.

It is sufficient for the materials to be contained in the protective layer to have a function capable of restraining the substances accelerating deterioration of elemental device, e.g., water, oxygen, etc., from entering the device.

The specific examples of such materials include metals, e.g., In, Sn, Pb, Au, Cu, Ag, Al, Ti, Ni, etc., metal oxides, e.g., MgO, SiO, SiO₂, Al₂O₃, GeO, NiO, CaO, BaO, Fe₂O₃, Y₂O₃, TiO₂, etc., metal nitrides, e.g., SiNₓ, SiNₓO_{y}, etc., metal fluorides, e.g., MgF₂, LiF, AlF₃, CaF₂, etc., polyethylene, polypropylene, polymethyl methacrylate, polyimide, polyurea, polytetrafluoroethylene, polychlorotrifluoroethylene, polydichlorodifluoroethylene, copolymers of chlorotrifluoroethylene with dichlorodifluoroethylene, copolymers obtained by copolymerization of a monomer mixture containing tetrafluoroethylene and at least one comonomer, fluorine-containing copolymers having a cyclic structure on the main chain of the copolymer, water absorptive substances having a water absorption rate of not lower than 1%, and moisture proofing substances having a water absorption rate of not higher than 0.1%.

The forming method of the protective layer is not especially restricted and, for example, a vacuum deposition method, a sputtering method, a reactive sputtering method, an MBE (molecular beam epitaxy) method, a cluster ion beam method, an ion plating method, a plasma polymerization method (a high frequency excitation ion plating method), a plasma CVD method, a laser CVD method, a heat CVD method, a gas source CVD method, a coating method, a printing method, a transfer method, etc., can be applied to the invention.

### Sealing:

A device of the invention may be completely sealed in a sealing container.

Further, a water absorber or an inert liquid may be filled in the space between the sealing container and the light-emitting device. The water absorber is not especially restricted and, for example, barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, magnesium oxide, etc., can be exemplified. The inert liquid is not particularly limited and, for example, paraffins, liquid paraffins, fluorine solvents, such as perfluoroalkane, perfluoroamine, perfluoroether, etc., chlorine solvents, and silicone oils are exemplified.

Luminescence can be obtained by the application of DC (if necessary, an alternating current factor may be contained) voltage (generally from 2 to 15 V) or DC electric current between the anode and cathode of a device of the invention.

In connection with the driving methods of a device of the invention, the driving methods disclosed in JP-A-2-148687, JP-A-6-301355, JP-A-5-29080, JP-A-7-134558, JP-A-8-234685, JP-A-8-241047, Japanese Patent No. 2784615, and US 5,828,429 and US 6,023,308 can be used.

A device of the invention can be preferably used in display devices, displays, backlights, electrophotography, illumination light sources, recording light sources, exposure light sources, reading light sources, indicators, signboards, interior designs, optical communications, and the like.

### Examples

The invention will be described in further detail with reference to examples, but the invention should not be construed as being restricted thereto.

### Synthesis of exemplified compound:

Exemplified compound (1-3) can be synthesized by coupling carbazole-d8 containing deuterium atoms on 1- to 8-positions described in Heterocycles, Vol. 67, No. 1, 353-359 (2006) with 4,4'-dibromobiphenyl by using a palladium catalyst or a copper catalyst.

Exemplified compound (4-3) can be synthesized by the coupling with 1,3-dibromobenzene in the same manner as in exemplified compound (1-3).

Exemplified compound (12-3) can be synthesized by the coupling with 3,6-dibromo-9-phenylcarbazole described in Tetrahedron, Vol. 54, No. 42, 12707-12714 (1998) in the same manner as in exemplified compound (1-3).

Exemplified compound (4-6) can be synthesized according to the following method.

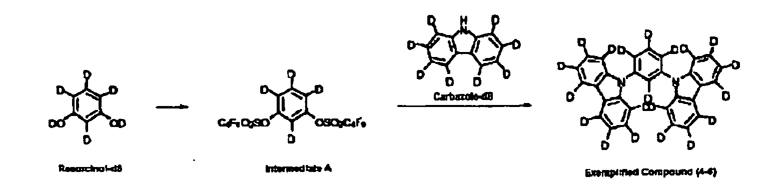

Resorcinol-d6 can be synthesized according to the method described in J. Am. Chem. Soc., Vol. 126, No. 40, 13033-03043 (2004).

Resorcinol-d6 (4.6 g) and triethylamine (14 ml) are mixed in dehydrated acetonitrile (40 ml). While cooling the reaction vessel with a water bath, nonafluorobutanesulfonyl fluoride (15.5 ml) is added. After stirring the reaction mixture at room temperature for 3 hours, water is added and the reaction product is extracted with a mixed solvent of hexane-ethyl acetate. The organic layer after extraction is washed with dilute hydrochloric acid, water and saturated brine in this order, dried with anhydrous sodium sulfate, and then the solvent is distilled off under reduced pressure to obtain 25.9 g of a crude product of intermediate A.

The crude product of intermediate A (13.6 g), carbazole-d8 (7.0 g), bis(benzylideneacetone) palladium (0.56 g), Xant Phos (CAS No. 161265-03-8, 1.16 g), and rubidium carbonate (23 g) are mixed in toluene (200 ml) in nitrogen atmosphere, and the mixture is refluxed with heating. After the elapse of 8 hours, bis(benzylideneacetone) palladium (0.28 g) is additionally added, and the reaction mixture is refluxed with heating for further 3 hours. After cooling to room temperature, water and ethyl acetate are added to the reaction mixture, and an organic layer obtained by filtering the insoluble matter is washed with water and saturated brine, and dried with anhydrous sodium sulfate. A crude product obtained by the concentration of the organic layer under reduced pressure is purified by silica gel column chromatography (a mixed eluent of hexane/ethyl acetate having a volume ratio of 20), and further subjected to recrystallization and sublimation purification to obtain 2.7 g of exemplified compound (4-6).

The degree of deuteriumation of exemplified compound (4-6) measured by ¹H-NMR with 1,2-dibromobutane as the internal standard substance, and heavy chloroform and heavy dimethyl sulfoxide as the solvents is 96% at every position.

In the above manufacturing method, when a defined substituent changes under the condition of a certain synthesizing method, or when it is not suitable to perform the method, the manufacture is easily possible by the means such as protection or deprotection of the functional groups (for example, T.W. Greene, Protective Groups in Organic Synthesis, John Wiley & Sons Inc. (1981)). Further, if necessary, it is also possible to arbitrarily change the order of the reaction processes such as the introduction of substituents and the like.

### Manufacture and evaluation of organic electroluminescent device:

### (1) Manufacture of organic electroluminescent device (A-1) for comparative example:

A glass substrate having an ITO layer having a thickness of 0.5 mm and 2.5 cm square (manufactured by Geomatec Co., Ltd., surface resistance: 10 Ω/□) is put in a washer and subjected to ultrasonic washing in 2-propanol, and then UV-ozone treatment for 30 minutes. The following organic layers are deposited in order on the transparent anode (ITO film) by vacuum deposition.

The deposition speed in the examples of the specification is 0.2 nm/sec unless otherwise indicated. The deposition speed is measured with a quartz oscillator film formation controller, CRTM-9000 (manufactured by ULVAC, Inc.). The layer thickness of each film shown below is also computed from the calibration curves formed from the numeric value of CRTM-9000 and the thickness measured with a Dektak tracer type thickness meter.
<1> Compound A: Layer thickness: 80 nm
<2> Compound B: Layer thickness: 10 nm
<3> Co-deposition of Comparative Compound 1 + light-emitting material A (10 wt%): Layer thickness: 60 nm
<4> Compound C: Layer thickness: 10 nm
<5> Compound D: Layer thickness: 30 nm

Finally, 0.1 nm of lithium fluoride and metal aluminum are deposited in this order in a thickness of 100 nm to prepare a cathode. This is put in a glove box replaced with argon gas so as not to be contact with the air, and sealed with a stainless steel sealing can and a UV-curing type adhesive (XNR5516HV, manufactured by Nagase Ciba) to thereby obtain an organic electroluminescent device for comparison.

### (2) Manufacture of organic electroluminescent device (B-1) for comparative example:

Organic electroluminescent device (B-1) for comparative example is manufactured in the same manner as in the manufacture of (A-1), except for changing light-emitting material A to light-emitting material B having the structure shown below and comparative compound 1 to comparative compound 2.

### (3) Manufacture of organic electroluminescent device (C-1) for comparative example:

Organic electroluminescent device (C-1) for comparative example is manufactured in the same manner as in the manufacture of (B-1), except that a layer of comparative compound 3 having a thickness of 3 nm is inserted between the layer of compound B and the layer containing light-emitting material B.

### (4) Manufacture of organic electroluminescent device (D-1) for comparative example:

Organic electroluminescent device (D-1) for comparative example is manufactured in the same manner as in the manufacture of (A-1), except for changing light-emitting material A to light-emitting material C having the structure shown below.

### (5) Manufacture of organic electroluminescent device (E-1) for comparative example:

Organic electroluminescent device (E-1) for comparative example is manufactured in the same manner as in the manufacture of (A-1), except for changing light-emitting material A to light-emitting material D having the structure shown below and comparative compound 1 to comparative compound 2.

### (6) Manufacture of organic electroluminescent device (D-2) for comparative example:

Organic electroluminescent device (D-2) for comparative example is manufactured in the same manner as in the manufacture of (D-1), except for changing comparative compound 1 to exemplified compound (1-3) disclosed in the specification.

### (7) Manufacture of organic electroluminescent device (E-2) for comparative example:

Organic electroluminescent device (E-2) for comparative example is manufactured in the same manner as in the manufacture of (E-1), except for changing comparative compound 2 to exemplified compound (4-6) disclosed in the specification.

### (8) Manufacture of organic electroluminescent device (A-2) for example in the invention:

Organic electroluminescent device (A-2) of the invention is manufactured in the same manner as in the manufacture of (A-1), except for changing comparative compound 1 to exemplified compound (1-3) disclosed in the specification.

### (9) Manufacture of organic electroluminescent device (B-2) for example in the invention:

Organic electroluminescent device (B-2) of the invention is manufactured in the same manner as in the manufacture of (B-1), except for changing comparative compound 2 to exemplified compound (4-6) disclosed in the specification.

### (10) Manufacture of organic electroluminescent device (C-2) for example in the invention:

Organic electroluminescent device (C-2) of the invention is manufactured in the same manner as in the manufacture of (C-1), except for changing comparative compound 2 to exemplified compound (4-6) of the invention, and comparative compound 3 to exemplified compound (12-2) disclosed in the specification.

The chemical structures of compound A to compound D are as shown below.

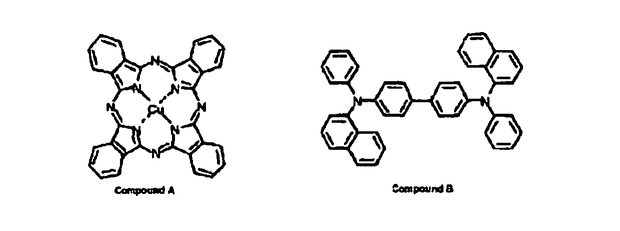

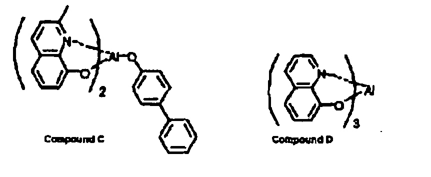

The chemical structures of light-emitting material A to light-emitting material D are as shown below.

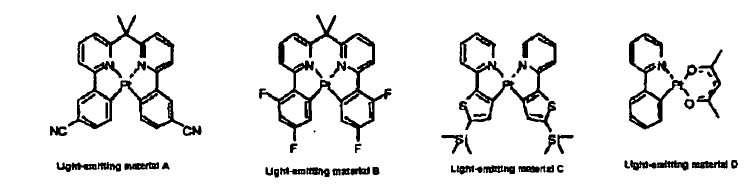

The chemical structures of comparative compounds 1 to 3 are as shown below.

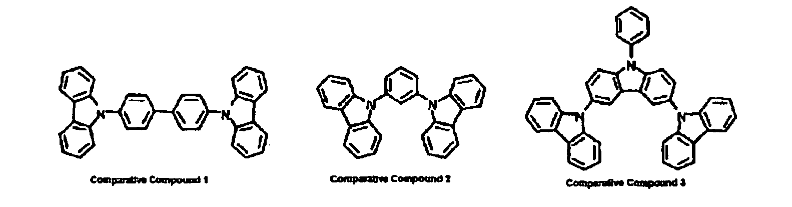

Organic electroluminescent devices (A-1) to (E-2) obtained as above are evaluated according to the following methods.

### (1) Measurement of driving voltage

Each of organic electroluminescent devices (A-1) to (E-2) is set on an emission spectrum measuring system, ELS1500 (manufactured by Shimadzu Corporation), and the applied voltage is measured when the luminance is 100 Cd/m².

### (2) Evaluation of driving durability

Each of organic electroluminescent devices (A-1) to (E-2) is set on OLED test system ST-D type (manufactured by TSK Co.), and the device is driven on the condition of normal direction constant current of 0.4 mA by constant current mode, and half life of luminance (time required for luminance to lower to 50% from the initial luminance) is found.

In organic electroluminescent device (A-2) of the invention, driving voltage is 0.85 times lower than that and half life of luminance is 1.8 times higher than that of comparative (A-1).

In organic electroluminescent device (B-2) of the invention, driving voltage is 0.80 times lower than that and half life of luminance is 2.0 times higher than that of comparative (B-1).

In organic electroluminescent device (C-2) of the invention, driving voltage is 0.75 times lower than that and half life of luminance is 2.3 times higher than that of comparative (C-1).

In organic electroluminescent device (D-2) for comparative example, driving voltage is 1.00 time lower than that and half life of luminance is 1.1 times higher than that of comparative (D-1).

In organic electroluminescent device (E-2) for comparative example, driving voltage is 0.95 time lower than that and half life of luminance is 1.2 times higher than that of comparative (E-1).

The above results are summarized in Table 1 below. Those using the materials not containing a deuterium atom are taken as comparative examples. The results of the examples using the materials of the invention containing a deuterium atom are shown in relative values with the results of comparative examples as 100. (For example, Comparative Example A-1 and Example A-2 are compared.)

**Table 1**

| Light-emitting Device | Light-Emitting Material | Host Material | Driving Voltage | Half Life of Luminance |
|---|---|---|---|---|
| Comparative Example A-1 | Light-emitting material A | Comparative Compound 1 | 100 | 100 |
| Example A-2 | Light-emitting material A | Exemplified Compound 1-3 | 85 | 180 |
| Comparative Example B-1 | Light-emitting material B | Comparative Compound 2 | 100 | 100 |
| Example B-2 | Light-emitting material B | Exemplified Compound 4-6 | 80 | 200 |
| Comparative Example C-1* | Light-emitting material B | Comparative Compound 2 | 100 | 100 |
| Example C-2** | Light-emitting material B | Exemplified Compound 4-6 | 75 | 230 |
| Comparative Example D-1 | Light-emitting material C | Comparative Compound 1 | 100 | 100 |
| Comparative Example D-2 | Light-emitting material C | Exemplified Compound 1-3 | 100 | 110 |
| Comparative Example E-1 | Light-emitting material D | Comparative Compound 2 | 100 | 100 |
| Comparative Example E-2 | Light-emitting material D | Exemplified Compound 4-6 | 95 | 120 |

| | | | | |
|---|---|---|---|---|
| * Having the layer in a thickness of 3 nm of Comparative Compound 3 (see the text). ** Having the layer in a thickness of 3 nm of Exemplified Compound (12-2) (see the text). | | | | |

From the above results, it has been shown that the organic electroluminescent devices of the invention using in combination of the compound represented by formula (1) and the platinum complex phosphorescent material having a tetradentate ligand have particularly conspicuous effect.

The devices of Comparative Examples 1 to 21 and Examples 1 to 18 are prepared in the same manner as in Comparative Example A-1 with the light-emitting materials and host materials (the materials used together with the light-emitting materials) shown in Table 2 below in combination, and evaluated similarly. The results obtained are shown in Table 2.

**Table 2**

| Light-emitting Device | Light-Emitting Material | Host Material | Driving Voltage | Half Life of Luminance |
|---|---|---|---|---|
| Comparative Example I | Light-emitting material A | Comparative Compound 4 | 100 | 100 |
| Example I | Light-emitting material A | Exemplified Compound 2-3 | 95 | 190 |
| Comparative Example 2 | Light-emitting material B | Comparative Compound 5 | 100 | 100 |
| Example 2 | Light-emitting material B | Exemplified Compound 3-1 | 98 | 180 |
| Comparative Example 3 | Light-emitting material B | Comparative Compound 6 | 100 | 100 |
| Example 3 | Light-emitting material B | Exemplified Compound 5-3 | 90 | 180 |
| Comparative Example 4 | light-emitting material B | Comparative Compound 7 | 100 | 100 |
| Example 4 | Light-emitting material B | Exemplified Compound 8-2 | 98 | 150 |
| Comparative Example 5 | Light-emitting material E | Comparative Compound 1 | 100 | 100 |
| Example 5 | Light-emitting material E | Exemplified Compound 1-3 | 85 | 180 |
| Comparative Example 6 | Light-emitting material E | Comparative Compound 5 | 100 | 100 |
| Example 6 | Light-emitting material E | Exemplified Compound 3-1 | 89 | 160 |
| Comparative Example 7 | Light-emitting material F | Comparative Compound 4 | 100 | 100 |
| Example 7 | Light-emitting material F | Exemplified Compound 2-3 | 90 | 180 |
| Comparative Example 8 | Light-emitting material G | Comparative Compound 1 | 100 | 100 |
| Example 8 | Light-emitting material G | Exemplified Compound 1-3 | 87 | 170 |
| Comparative Example 9 | Light-emitting material G | Comparative Compound 4 | 100 | 100 |
| Example 9 | Light-emitting material G | Exemplified Compound 2-3 | 93 | 160 |
| Comparative Example 10 | Light-emitting material H | Comparative Compound 2 | 100 | 100 |
| Example 10 | Light-emitting material H | Exemplified Compound 4-1 | 85 | 200 |
| Comparative Example 11 | Light-emitting material H | Comparative Compound 9 | 100 | 100 |
| Example 11 | Light-emitting material H | Exemplified Compound 14-3 | 83 | 210 |
| Comparative Example 12 | Light-emitting material I | Comparative Compound 2 | 100 | 100 |
| Example 12 | Light-emitting material I | Exemplified Compound 4-4 | 95 | 140 |
| Comparative Example 13 | Light-emitting material I | Comparative Compound 7 | 100 | 100 |
| Example 13 | Light-emitting material I | Exemplified Compound 8-2 | 95 | 180 |
| Comparative Example 14 | Light-emitting material J | Comparative Compound 2 | 100 | 100 |
| Example 14 | Light-emitting material J | Exemplified Compound 4-6 | 85 | 250 |
| Comparative Example 15 | Light-emitting material J | Comparative Compound 8 | 100 | 100 |
| Example 15 | Light-emitting material J | Exemplified Compound 9-5 | 93 | 200 |
| Comparative Example 16 | Light-emitting material K | Comparative Compound 2 | 100 | 100 |
| Example 16 | Light-emitting material K | Exemplified Compound 4-6 | 90 | 150 |
| Comparative Example 17 | Light-emitting material L | Comparative Compound 1 | 100 | 100 |
| Example 17 | Light-emitting material L | Exemplified Compound 1-3 | 90 | 180 |
| Comparative Example 18 | Light-emitting material L | Comparative Compound 5 | 100 | 100 |
| Example 18 | Light-emitting material L | Exemplified Compound 3-1 | 85 | 220 |
| Comparative Example 19 | Light-emitting material M | Comparative Compound 1 | 100 | 100 |
| Comparative Example 19' | Light-emitting material M | Exemplified Compound 1-3 | 90 | 130 |
| Comparative Example 20 | Light-emitting material N | Comparative Compound 1 | 100 | 100 |
| Comparative Example 20' | Light-emitting material N | Exemplified Compound 1-3 | 95 | 120 |
| Comparative Example 21 | Light-emitting material O | Comparative Compound 1 | 100 | 100 |
| Comparative Example 21' | Light-emitting material O | Exemplified Compound 1-3 | 98 | 140 |

The chemical structures of light-emitting materials E to O are as follows.

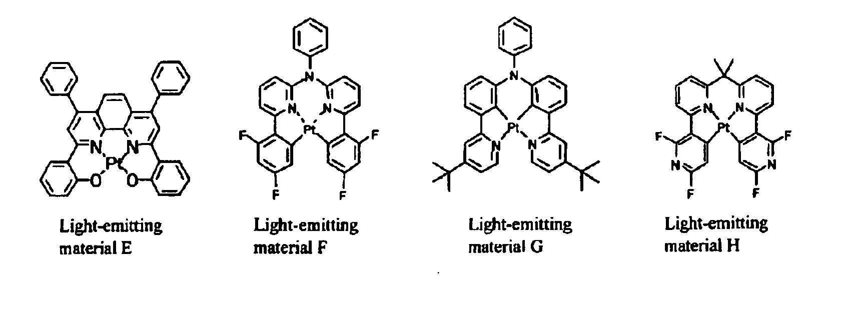

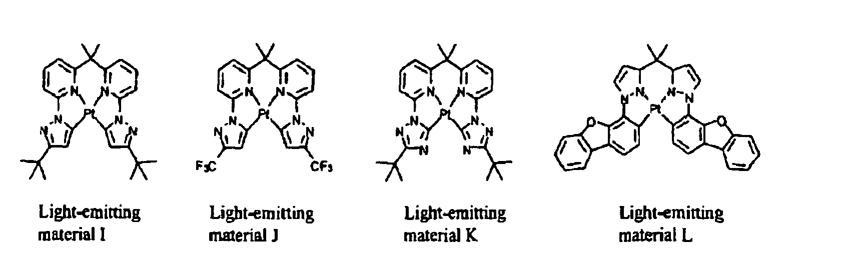

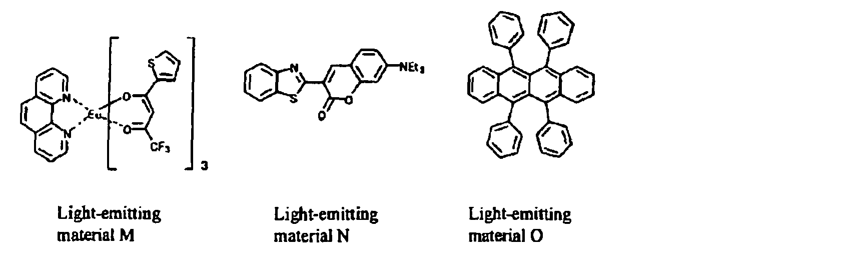

The chemical structures of Comparative Compounds 4 to 9 are as follows.

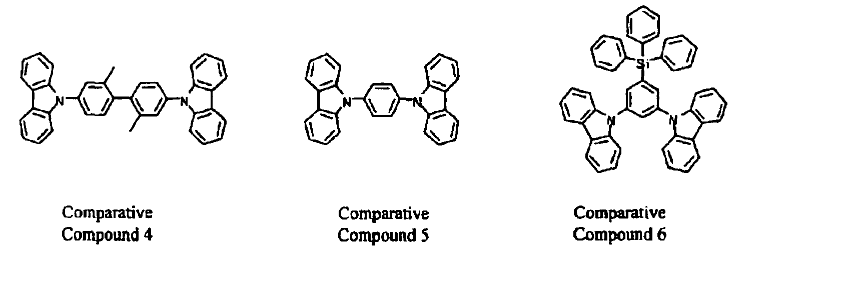

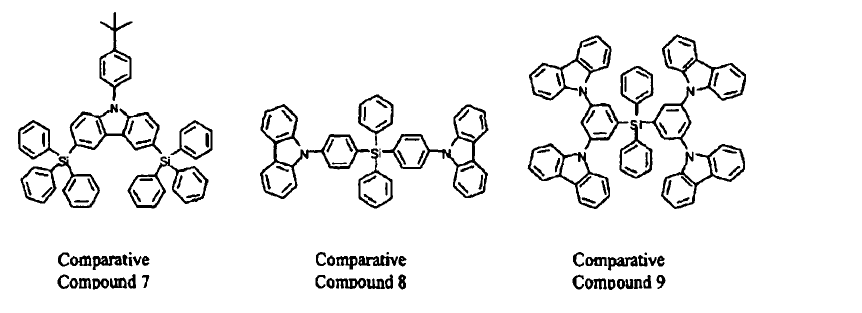

From the results in the above table, it has been confirmed that the organic electroluminescent devices of the invention using in combination of the compound represented by formula (I) and the platinum complex phosphorescent material having a tetradentate ligand have particularly conspicuous effect.

The devices of Comparative Examples 22 and 23 and Examples 22 and 23 are prepared in the same manner as in Comparative Example A-1, except that compound B and comparative compound 1 in organic electroluminescent device A-1 for comparison are changed to the materials shown in Table 3 below, and evaluated similarly. The results obtained are shown in Table 3.

**Table 3**

| Light-emitting Device | Layer of Compound B | Layer of Comparative Compound 1 | Driving Voltage | Half Life of Luminance |
|---|---|---|---|---|
| Comparative Example 22 | Comparative compound 5 | Comparative compound 1 | 100 | 100 |
| Example 22 | Exemplified compound 3-3 | Comparative compound 1 | 93 | 150 |
| Comparative Example 23 | Comparative compound 5 | Comparative compound 1 | 100 | 100 |
| Example 23 | Exemplified compound 3-3 | Exemplified compound 1-3 | 85 | 210 |

From the above results, it has been confirmed that the effect of the invention can also be obtained by using the compound represented by formula (I) in the organic layer contiguous to the light-emitting layer, and particularly conspicuous effect can be obtained by using the compound in each of the light-emitting layer and the organic layer contiguous to the light-emitting layer.

The devices of Comparative Examples 24 and 24' are prepared in the same manner as in Comparative Example A-1, except that comparative compound 1 and compound C in organic electroluminescent device A-1 for comparison are changed to the materials shown in Table 4 below, and evaluated similarly. The results obtained are shown in Table 4.

**Table 4**

| Light-emitting Device | Layer of Comparative Compound 1 | Layer of Compound C | Driving Voltage | Half Life of Luminance |
|---|---|---|---|---|
| Comparative Example 24 | Comparative compound 2 | Compound C | 100 | 100 |
| Comparative Example 24' | Comparative compound 2 | Compound E | 99 | 101 |

The chemical structure of Compound E is as follows.

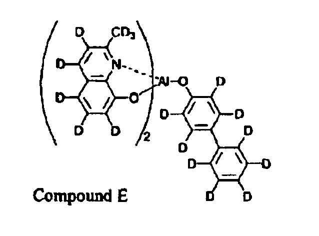

From the above results, it has been confirmed that the effect of the invention is not caused ubiquitously in the case where the materials containing a heavy hydrogen atom are used, but is peculiar to the materials represented by formula (I), also from the foregoing results.

It will be apparent to those skilled in the art that various modifications and variations can be made to the described embodiments of the invention without departing from the spirit or scope of the invention. Thus, it is intended that the invention cover all modifications and variations of this invention consistent with the scope of the appended claims and their equivalents.

The present application claims foreign priority based on Japanese Patent Application Nos. JP2007-85961 filed March 28, 2007, the contents of which are incorporated herein by reference.

## Claims

1. An organic electroluminescent device comprising:
a pair of electrodes; and
at least one organic layer between the pair of electrodes, the at least one organic layer including a light-emitting layer,
wherein the at least one organic layer contains a compound represented by formula (I), and the light-emitting layer contains a phosphorescent material of a platinum complex having a tetradentate ligand: 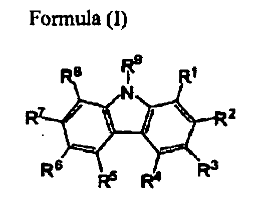 wherein R¹ to R⁸ each independently represents a hydrogen atom or a substituent, and contiguous groups of R¹ to R⁸ may be bonded to each other to form a condensed ring; R⁹ represents an alkyl group, an alkenyl group, an aryl group, a hetero aryl group, or a silyl group, and each group may be substituted with a substituent; and at least one of R¹ to R⁹ represents a deuterium atom or a substituent containing a deuterium atom.

2. The organic electroluminescent device according to claim 1, wherein the compound represented by formula (I) is contained in the light-emitting layer.

3. The organic electroluminescent device according to claim 1 or 2, wherein the compound represented by formula (I) is contained in an organic layer contiguous to the light-emitting layer.

4. The organic electroluminescent device according to any one of claims I to 3, wherein the compound represented by formula (I) is contained in the light-emitting layer and an organic layer contiguous to the light-emitting layer.

5. The organic electroluminescent device according to any one of claims 1 to 4, wherein the compound represented by formula (I) is a compound represented by formula (V): 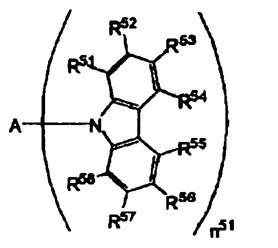 wherein R⁵¹ to R⁵⁸ each independently represents a hydrogen atom or a substituent, and contiguous substituents of R⁵¹ to R⁵⁸ may be bonded to each other to form a condensed ring; A represents a linking group; n⁵¹ represents an integer of from 2 to 6; and the compound represented by formula (V) contains at least one deuterium atom.

6. The organic electroluminescent device according to any one of claims 1 to 5, wherein the phosphorescent material includes a compound represented by one of formulae (A), (B), (E) and (F): 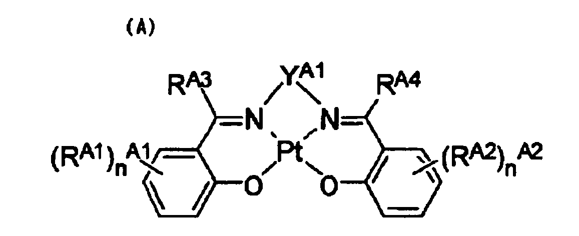 wherein R^{A3} and R^{A4} each independently represents a hydrogen atom or a substituent; R^{A1} and R^{A2} each independently represents a substituent, and when a plurality of R^{A1} and R^{A2} are present, the plurality of R^{A1} and R^{A2} may be the same or different, and R^{A1} and R^{A2} may be connected to each other to form a ring; n^{A1} and n^{A2} each independently represents an integer of from 0 to 4; and Y^{A1} represents a linking group; 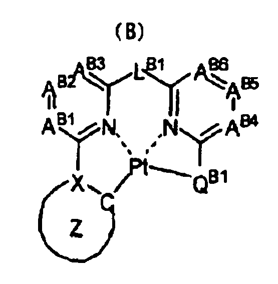 wherein A^{B1} to A^{B6} each independently represents C-R or N; R represents a hydrogen atom or a substituent; L^{B1} represents a single bond or a divalent linking group; X represents C or N; Z represents a 5- or 6-membered aromatic ring or heteroaromatic ring formed together with X-C; and Q^{B1} represents an anionic group bonding to Pt; 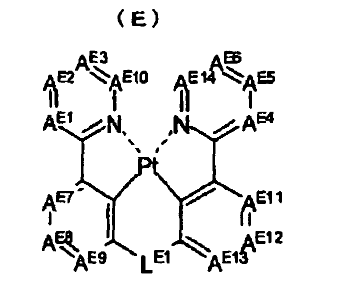 wherein A^{E1} to A^{E14} each independently represents C-R or N; R represents a hydrogen atom or a substituent; and L^{E1} represents a single bond or a divalent linking group; 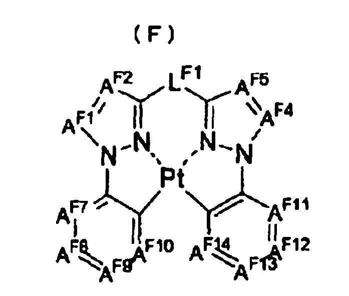 wherein A^{F1} to A^{F14} each independently represents C-R or N; R represents a hydrogen atom or a substituent; and L^{F1} represents a single bond or a divalent linking group.

## Patentansprüche

1. Organische Elektrolumineszenzvorrichtung, umfassend:
ein Paar Elektroden; und
mindestens eine organische Schicht zwischen dem Paar Elektroden, wobei die mindestens eine organische Schicht eine lichtemittierende Schicht umfasst,
worin die mindestens eine organische Schicht eine Verbindung, die durch die Formel (I) dargestellt ist, umfasst und die lichtemittierende Schicht ein phosphoreszierendes Material aus einem Platinkomplex, der einen 4-zähnigen Liganden aufweist, umfasst: 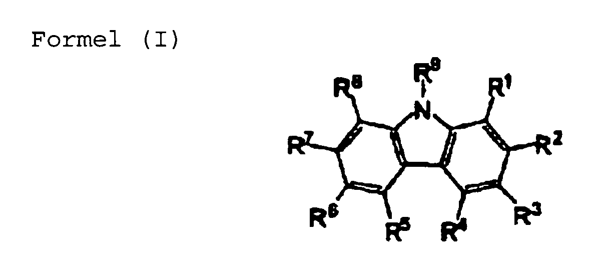 worin R¹ bis R⁸ jeweils unabhängig voneinander ein Wasserstoffatom oder einen Substituenten darstellen und benachbarte Gruppe von R¹ bis R⁸ miteinander verbunden sein können, um einen kondensierten Ring zu bilden; R⁹ eine Alkylgruppe, eine Alkenylgruppe, eine Arylgruppe, eine Heteroarylgruppe oder eine Silylgruppe darstellt und jede Gruppe mit einem Substituenten substituiert sein kann; und mindestens eines von R¹ bis R⁹ ein Deuteriumatom oder einen Substituenten, der ein Deuteriumatom enthält, darstellt.

2. Organische Elektrolumineszenzvorrichtung gemäß Anspruch 1, worin die durch die Formel (I) dargestellte Verbindung in der lichtemittierenden Schicht enthalten ist.

3. Organische Elektrolumineszenzvorrichtung gemäß Anspruch 1 oder 2, worin die durch die Formel (I) dargestellte Verbindung in einer organischen Schicht enthalten ist, die an die lichtemittierende Schicht angrenzt.

4. Organische Elektrolumineszenzvorrichtung gemäß irgendeinem der Ansprüche 1 bis 3, worin die durch die Formel (I) dargestellte Verbindung in der lichtemittierenden Schicht und einer organischen Schicht, die an die lichtemittierende Schicht angrenzt, enthalten ist.

5. Organische Elektrolumineszenzvorrichtung gemäß irgendeinem der Ansprüche 1 bis 4, worin die durch die Formel (I) dargestellte Verbindung eine durch die Formel (V) dargestellte Verbindung ist: 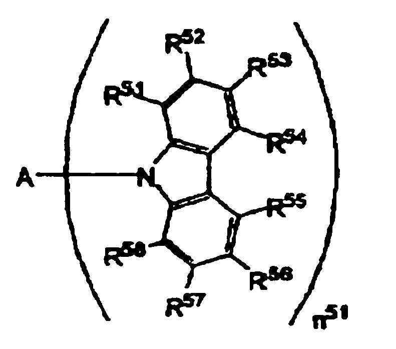 worin R⁵¹ bis R⁵⁸ jeweils unabhängig voneinander ein Wasserstoffatom oder einen Substituenten darstellen und benachbarte Substituenten von R⁵¹ bis R⁵⁸ miteinander verbunden sein können, um einen kondensierten Ring zu bilden; A eine Verknüpfungsgruppe darstellt; n⁵¹ eine ganze Zahl von 2 bis 6 darstellt; und die durch die Formel (V) dargestellte Verbindung mindestens ein Deuteriumatom enthält.

6. Organische Elektrolumineszenzvorrichtung gemäß irgendeinem der Ansprüche 1 bis 5, worin das phosphoreszierende Material eine durch eine der Formeln (A), (B), (E) und (F) dargestellte Verbindung umfasst: 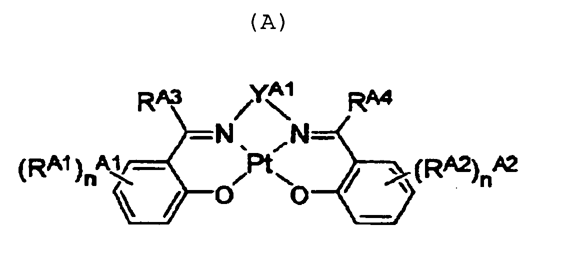 worin R^{A3} und R^{A4} jeweils unabhängig voneinander ein Wasserstoffatom oder einen Substituenten darstellen; R^{A1} und R^{A2} jeweils unabhängig voneinander einen Substituenten darstellen, und wenn mehrere R^{A1} und R^{A2} vorliegen, die mehreren R^{A1} und R^{A2} gleich oder verschieden sein können, und R^{A1} und R^{A2} miteinander verbunden sein können, um einen Ring zu bilden; n^{A1} und n^{A2} jeweils unabhängig voneinander eine ganze Zahl von 0 bis 4 darstellen; und Y^{A1} eine Verknüpfungsgruppe darstellt; 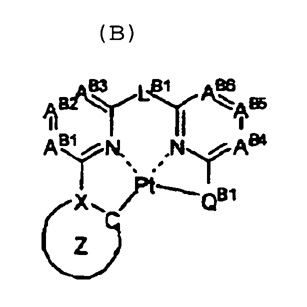 worin A^{B1} bis A^{B6} jeweils unabhängig voneinander C-R oder N darstellen; R ein Wasserstoffatom oder einen Substituenten darstellt; L^{B1} eine Einfachbindung oder eine divalente Verknüpfungsgruppe darstellt; X C oder N darstellt; Z einen 5- oder 6-gliedrigen aromatischen Ring oder heteroaromatischen Ring, gebildet zusammen mit X-C, darstellt; und Q^{B1} eine anionische Gruppe, die an Pt bindet, darstellt; 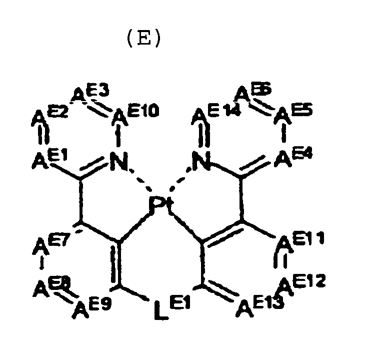 worin A^{E1} bis A^{E14} jeweils unabhängig voneinander C-R oder N darstellen; R ein Wasserstoffatom oder einen Substituenten darstellt; und L^{E1} eine Einfachbindung oder eine divalente Verknüpfungsgruppe darstellt; 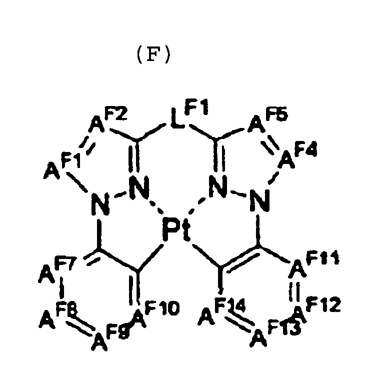 worin A^{F1} bis A^{F14} jeweils unabhängig voneinander C-R oder N darstellen; R ein Wasserstoffatom oder einen Substituenten darstellt; und L^{F1} eine Einfachbindung oder eine divalente Verknüpfungsgruppe darstellt.

## Revendications

1. Dispositif organique électroluminescent comprenant :
une paire d'électrodes ; et
au moins une couche organique entre la paire d'électrodes, l'au moins une couche organique incluant une couche électroluminescente,
dans lequel l'au moins une couche organique contient un composé représenté par la formule (I), et la couche électroluminescente contient une matière phosphorescente d'un complexe de platine ayant un ligand tétradenté : 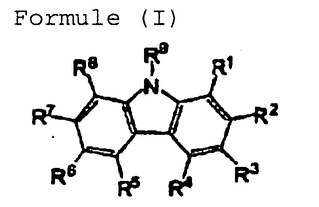
dans laquelle R¹ à R⁸ représentent chacun indépendamment un atome d'hydrogène ou un substituant, et des groupes contigus de R¹ à R⁸ peuvent être liés les uns aux autres pour former un cycle condensé ; R⁹ représente un groupe alkyle, un groupe alcényle, un groupe aryle, un groupe hétéro aryle, ou un groupe silyle, et chaque groupe peut être substitué par un substituant ; et au moins un de R¹ à R⁹ représente un atome de deutérium ou un substituant contenant un atome de deutérium.

2. Dispositif organique électroluminescent selon la revendication 1, dans lequel le composé représenté par la formule (I) est contenu dans la couche électroluminescente.

3. Dispositif organique électroluminescent selon la revendication 1 ou 2, dans lequel le composé représenté par la formule (1) est contenu dans une couche organique contiguë à la couche électroluminescente.

4. Dispositif organique électroluminescent selon l'une quelconque des revendications 1 à 3, dans lequel le composé représenté par la formule (I) est contenu dans la couche électroluminescente et une couche organique contiguë à la couche électroluminescente.

5. Dispositif organique électroluminescent selon l'une quelconque des revendications 1 à 4, dans lequel le composé représenté par la formule (1) est un composé représenté par la formule (V) : 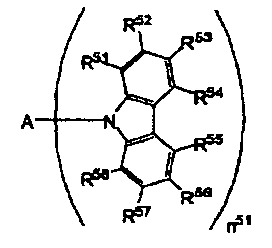 dans laquelle R⁵¹ à R⁵⁸ représentent chacun indépendamment un atome d'hydrogène ou un substituant, et des substituants contigus de R⁵¹ à R⁵⁸ peuvent être liés les uns aux autres pour former un cycle condensé ; A représente un groupe de liaison ; n⁵¹ représente un entier de 2 à 6 ; et le composé représenté par la formule (V) contient au moins un atome de deutérium.

6. Dispositif organique électroluminescent selon l'une quelconque des revendications 1 à 5, dans lequel la matière phosphorescente inclut un composé représenté par une des formules (A), (B), (E) et (F) : 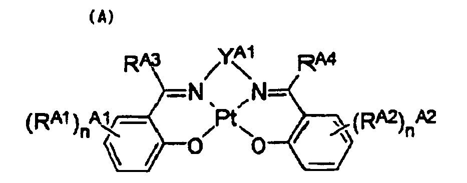 dans laquelle R^{A3} et R^{A4} représentent chacun indépendamment un atome d'hydrogène ou un substituant ; R^{A1} et R^{A2} représentent chacun indépendamment un substituant, et quand une pluralité de R^{A1} et R^{A2} sont présents, la pluralité de R^{A1} et R^{A2} peut être la même ou différente, et R^{A1} et R^{A2} peuvent être reliés l'un à l'autre pour former un cycle ; n^{A1} et n^{A2} représentent chacun indépendamment un entier de 0 à 4 ; et Y^{A1} représente un groupe de liaison ; 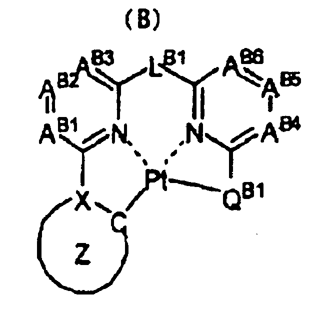 dans laquelle A^{B1} à A^{B6} représentent chacun indépendamment C-R ou N ; R représente un atome d'hydrogène ou un substituant ; L^{B1} représente une liaison simple ou un groupe de liaison divalent ; X représente C ou N ; Z représente un cycle aromatique à 5 ou à 6 éléments ou un cycle hétéroaromatique formé ensemble avec X-C ; et Q^{B1} représente un groupe anionique se liant au Pt ; 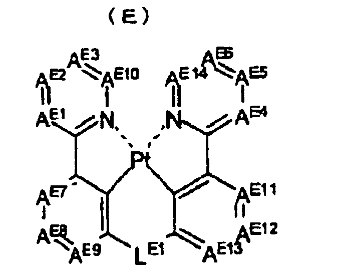 dans laquelle A^{E1} à A^{E14} représentent chacun indépendamment C-R ou N ; R représente un atome d'hydrogène ou un substituant ; et L^{E1} représente une liaison simple ou un groupe de liaison divalent ; 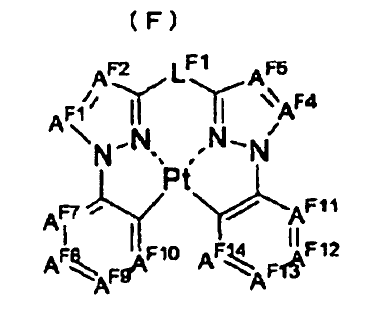 dans laquelle A^{F1} à A^{F14} représentent chacun indépendamment C-R ou N ; R représente un atome d'hydrogène ou un substituant ; et L^{F1} représente une liaison simple ou un groupe de liaison divalent.
